# EUROPEAN PATENT SPECIFICATION

(11) **EP 2 071 394 B1**
(45) Date of publication and mention of the grant of the patent: **26.10.2011**
(21) Application number: 07742948.8
(22) Date of filing: 08.05.2007
(51) Int. Cl.: G02F 1/1368, H01L 29/786

(54) **ACTIVE MATRIX SUBSTRATE AND LIQUID CRYSTAL DISPLAY DEVICE PROVIDED WITH SAME**
AKTIVMATRIXSUBSTRAT UND DAMIT AUSGESTATTETE FLÜSSIGKRISTALLANZEIGEANORDNUNG
SUBSTRAT DE MATRICE ACTIVE ET DISPOSITIF D'AFFICHAGE À CRISTAUX LIQUIDES DOTÉ DE CELUI-CI

(30) Priority: 27.09.2006 JP 2006263506
(43) Date of publication of application: 17.06.2009
(73) Proprietor: Sharp Kabushiki Kaisha, Osaka-shi, Osaka 545-8522 (JP)
(72) Inventor: MURAI, Atsuhito, Setagaya-ku, Tokyo 158-0081 (JP)
(74) Representative: Müller - Hoffmann & Partner
(86) International application number: PCT/JP2007/059513
(87) International publication number: WO 2008/038432

(56) References cited:
- JP-A- 2001 056 476
- JP-A- 2003 207 797
- JP-A- 2004 012 731
- JP-A- 2004 165 286
- US-A1- 2001 040 662

## Description

### TECHNICAL FIELD

The present invention relates to an active matrix substrate which incorporates a TFT, and a liquid crystal display device including the active matrix substrate.

### BACKGROUND ART

There has been known of liquid crystal display devices of an FFS (Fringe Field Switching) mode. A liquid crystal display device of the FFS mode is arranged such that a counter electrode and a pixel electrode (i) are formed by transparent material such as ITO, (ii) have a narrower space between the counter electrode and the pixel electrode than a space between the upper and lower substrates, and further (iii) have a width between the counter electrode and the pixel electrode in a degree in which all of liquid molecules aligned on an upper part of an electrode are drivable.

The liquid crystal display device of the FFS mode can attain a higher aperture ratio than that of a liquid crystal display device of an IPS (In-Place-Switching) mode, since the electrodes and the like are formed by the transparent material. That is to say, a higher aperture ratio than that of the IPS mode is attainable by causing light transmission to occur at an electrode section.

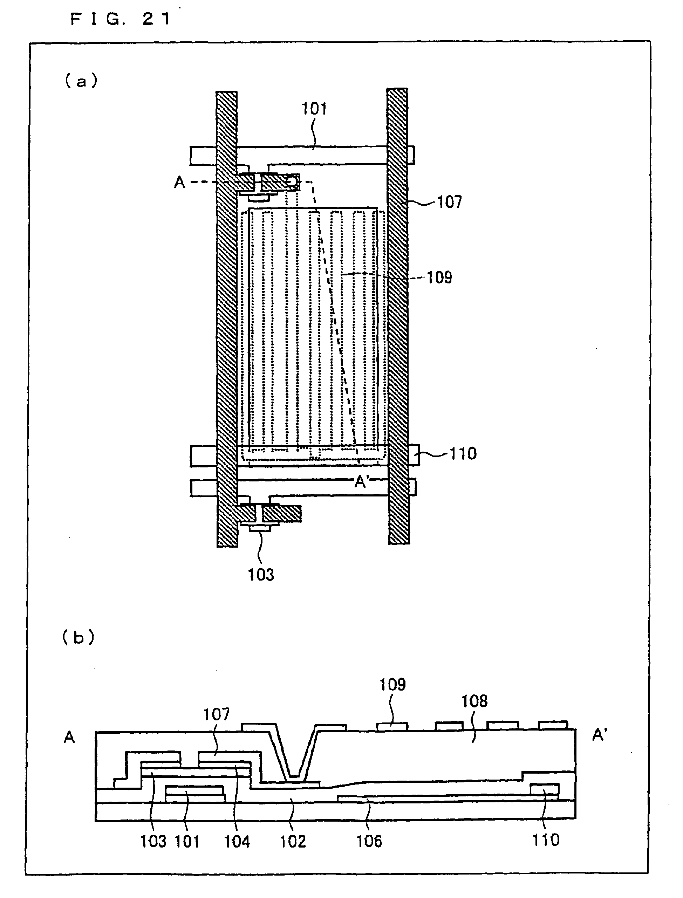

In Fig. 21, (a) is a plane view of an active matrix substrate to be used in a liquid crystal display device of the FFS mode, as described in Patent Document 1, and (b) is a cross sectional view taken on line A-A' indicated in (a) of Fig. 21.

As illustrated in (a) of Fig. 21, the active matrix substrate mainly includes: a plurality of gate bus lines 101 and a plurality of source bus lines 107 which orthogonally intersect with each other; a plurality of pixel electrodes 109 provided comblike and parallel to the source bus lines 107 in pixel areas surrounded by the gate and source bus lines, respectively; TFTs 103 provided on sections in which the gate bus lines 101 diverge to the pixel area side; and common electrode wires (CS wires) 110 provided parallel to the gate bus lines 101.

Further, as illustrated in (b) of Fig. 21, the active matrix substrate has common electrodes (gate bus line lower layer) 106 which consist of a transparent conductive film on an insulating substrate. Further, on the common electrodes 106 are provided a gate bus line upper layer 101 and CS wires 110. Moreover, a semiconductor layer 103, a contact layer 104, and a source/drain electrode upper layer 107 are stacked on the gate bus line upper layer 101 sandwiching a gate insulating film 102 between the semiconductor layer 103 and the gate bus line upper layer 101, so as to form a TFT. On an uppermost layer of the active matrix substrate is provided pixel electrodes 109 via an interlayer insulating film (passivation film) 108.

The active matrix substrate described in Patent Document 1 has the following two problems, caused by the common electrodes which form the CS wires 110 being provided on the gate bus line lower layer 106.

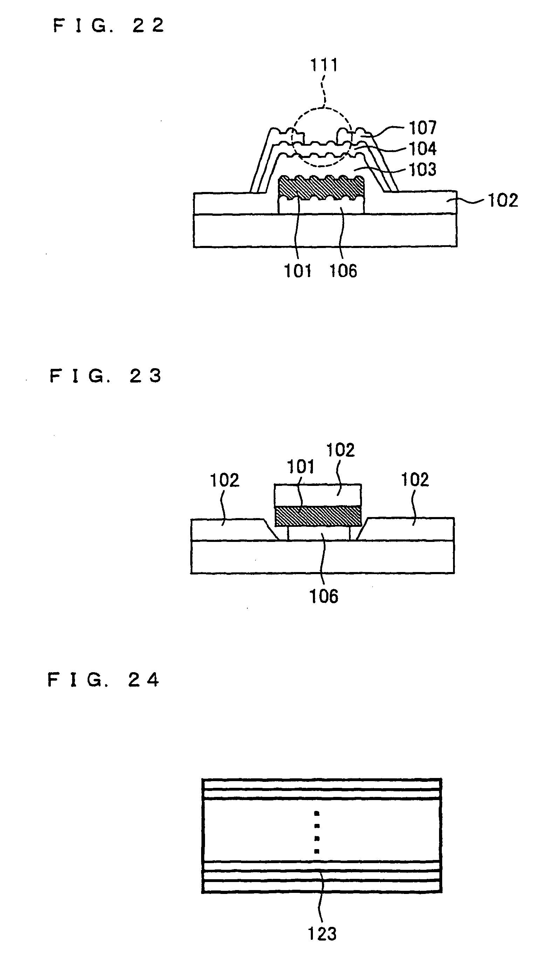

Namely, as illustrated in Fig. 22, roughening of the common electrodes and the gate bus line upper layer causes the semiconductor layer 103, the contact layer 104, and the source/drain electrode upper layer 107 that are provided on the gate insulating film 102 to also roughen. Note that the semiconductor layer 103, the contact layer 104, and the source/drain electrode upper layer 107 form a channel section 111 of the TFT. Particularly, in a case where a common transparent metal film is used as transparent electrodes, the flatness becomes low. This causes the roughness of the channel section 111 of the TFT to increase. As a result, a problem of a decrease in mobility occurs.

Moreover, the transparent electrodes have an extremely low transition temperature of crystallization, that is, the transparent electrodes polysiliconize (crystallize) from an amorphous state at around a temperature in a range of 150 ° to 200 °. When the transparent electrodes are compared between a crystallized state and the amorphous state, a large difference is recognized in an etching rate. Therefore, polysiliconization of the transparent electrodes causes a need to etch for a remarkably long period of time. Namely, as illustrated in Fig. 23, over-etching is required. As a result, the gate bus lines 101 become back tapered (peaked), and the gate insulating film 102 cannot cover the gate bus lines 101. This causes a problem that an efficiency percentage decreases, such as occurrence of leaking from the metal thin film formed on the upper layer.

An active matrix substrate described in Patent Document 2 provides common electrodes on a gate insulating film. In other words, the common electrodes are provided on a layer upper than the gate bus lines. Therefore, the two aforementioned problems are solved.

However, Patent Documents 1 and 2 both form the common electrodes parallel to the gate bus lines by use of a metal layer of the gate bus lines arranged horizontally to the liquid crystal display section. That is to say, the CS wires 123 are horizontally provided, as illustrated in Fig. 24. Generally, in liquid crystal display devices, many liquid crystal display sections are wide-shaped. Therefore, the gate bus lines are longer as compared to the source bus lines. Consequently, the common electrodes formed at the CS wires 123 have a high resistance, which causes a problem of signal delay. However in order to solve this problem, if a width of the CS wires 123 is thickened so as to aim for low resistance, another problem occurs that an aperture ratio decreases.

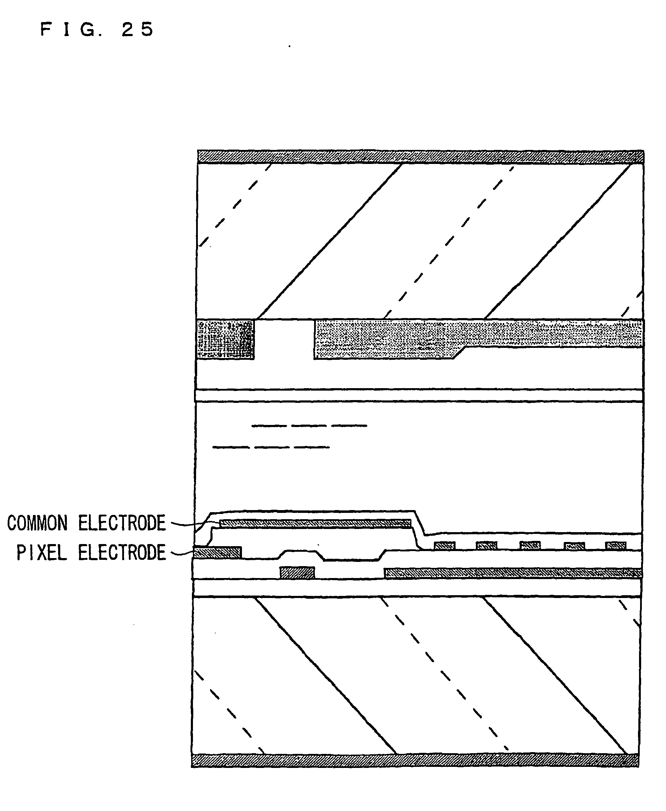

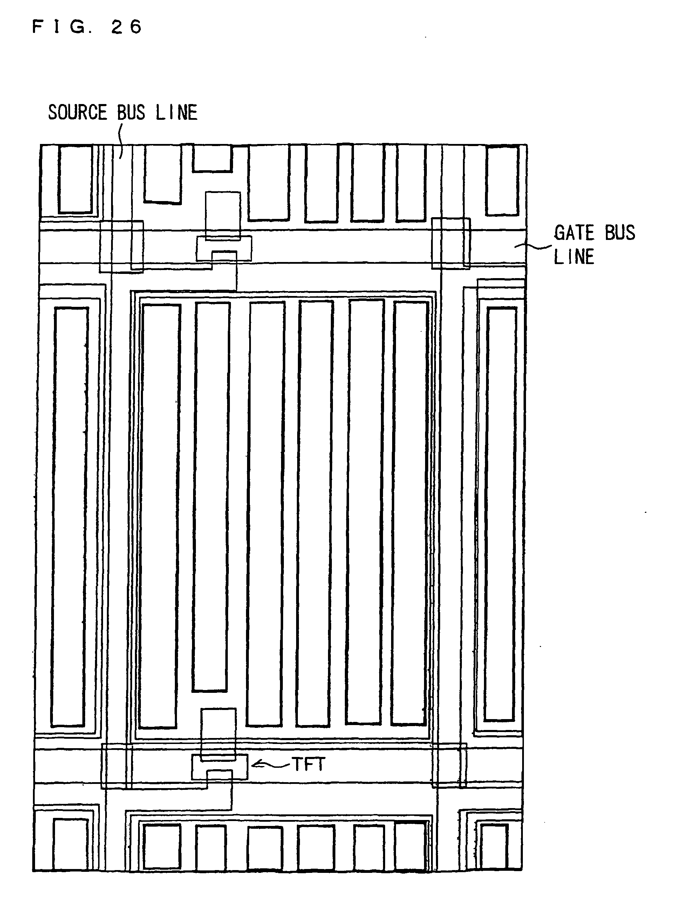

In response to this, Patent Document 3 provides the common electrodes (transparent electrode material, for example ITO) on a further upper position than the pixel electrodes, as illustrated in Fig. 25. The transparent electrode material is left remaining on all of an area except for a slit section of the common electrodes, so as to form the common electrodes. Further, as illustrated in Fig. 26, the transparent electrode material (CS wires) is provided on substantially the entire source bus lines and gate bus lines. As such, the problem of signal delay is solved by providing the CS wires parallel to the source bus lines.

### [Patent Document 1]

Japanese Unexamined Patent Publication No. 235763/2001 (Tokukai 2001-235763; published on August 31, 2001)
(Patent Document 2]
Japanese Unexamined Patent Publication No. 90781/2002 (Tokukai 2002-90781; published on March 27, 2002)
[Patent Document 3]
International Patent Publication No. WO 01/18597 (published on March 15, 2001)
[Patent Document 4]
Japanese Unexamined Patent Publication No. 221992/2001 (Tokukai 2001-221992; published on August 17, 2001)
[Patent Document 5]
Japanese Unexamined Patent Publication No. 230380/ 1997 (Tokukaihei 9-230380; published on September 5, 1997)

US 2001/040662 Al refers to a process for forming an in-plane switching mode liquid crystal display, which defines pixel portions of the common and data electrodes by the same photo-masking and lithography procedure. JP 2001-056476 A refers to a fringe field driven liquid crystal display device and its manufacture.

### DISCLOSURE OF INVENTION

However, in the technique disclosed in Patent Document 3, the CS wires are formed so as to cover the entire source bus lines and gate bus lines illustrated in Fig. 26. Therefore, defects such as a shortage and the like may possibly occur, and a parasitic capacitance between the gate and source bus lines and the CS wires increases.

The present invention is attained in view of the problems, and its purpose is to provide an active matrix substrate and a liquid crystal display device including the same that has small signal delay caused by resistance and small signal delay caused by parasitic capacitance.

The above objects are solved by the claimed matter according to the independent claims.

In order to attain the above object, an active matrix substrate of the present invention includes an insulating substrate; video signal lines and scanning signal lines provided orthogonally intersecting with each other on the insulating substrate; and thin film transistors provided at intersections of the video signal lines and the scanning signal lines, the thin film transistors including gate electrodes, source electrodes, and drain electrodes, respectively, a transparent electrode layer, formed to be used as a lower layer of the source electrodes and the drain electrodes, being used as (i) common electrodes provided in pixel areas surrounded by adjacent video signal lines and adjacent scanning signal lines, respectively and (ii) common electrode wires for connecting adjacent ones of the common electrodes parallel to the video signal lines.

According to the arrangement, a transparent electrode layer that is formed to be used as a lower layer of source electrodes and drain electrodes is used as (i) common electrodes provided in pixel areas surrounded by adjacent video signal lines and adjacent scanning signal lines, respectively and (ii) common electrode wires for connecting adjacent ones of the common electrodes parallel to the video signal lines. In other words, the common electrodes and the common electrode wires are formed by use of the transparent electrode layer that is to be used as a lower layer of the source electrodes and the drain electrodes. This allows the common electrodes to be connected and extended in a parallel direction to the video signal lines that are connected to the source electrodes. Generally, video signal lines are shorter than the scanning signal lines. Therefore, it is possible to reduce resistance as compared to the common electrodes being extended parallel to the scanning signal lines.

Furthermore, according to the arrangement, the common electrode wires do not have any part overlapping with the video signal lines, and are formed so as to overlap at a part where the common electrode wires orthogonally intersect with the scanning signal lines. When focused on one common electrode that is formed between adjacent video signal lines, generally a number of video signal lines is more than that of the scanning signal lines (video signal lines : scanning signal lines = 3(RGB) : 1). Therefore, a number of overlapping parts of the common electrodes and each signal lines (video signal lines, scanning signal lines) is reduced as compared to a conventional arrangement in which the common electrodes overlap at the parts orthogonally intersecting with the video signal lines. As a result, the parasitic capacitance of the common electrode wires is reduced.

As described above, the present invention reduces the resistance of the common electrodes and the common electrode wires, as well as reducing the parasitic capacitance between the common electrode wires and the signal lines. Therefore, it is possible to reduce the signal delay of the common electrode wires.

Further, according to the arrangement, a transparent electrode layer (transparent conductive material such as ITO) is formed as a lower layer of the source electrodes and the drain electrodes. This allows formation of the common electrodes in a same photolithography step as the formation of the source electrodes and the drain electrodes by use of a photolithography step that utilizes so-called halftone exposure. As a result, simplification of a manufacturing method is possible. In addition, since the common electrodes are formable in the same photolithography step, a decrease in yield rate caused by the photo alignment disposition and decrease in aperture ratio are prevented as compared to formation of the source and drain electrodes in a different photo step to the common electrodes, as in Patent Document 2 described above.

The active matrix substrate of the present invention is preferably arranged such that a metal film formed so as to create the gate electrodes is used as auxiliary common electrode wires that are provided parallel to the scanning signal lines, and the auxiliary common electrode wires and the common electrodes are electrically connected to each other via contact holes, respectively.

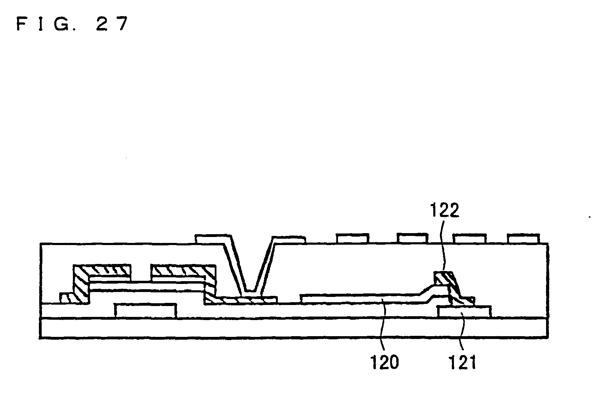

According to the arrangement, auxiliary common electrode wires are provided parallel to the scanning signal lines, and the auxiliary common electrode wires and the common electrodes are electrically connected to each other via contact holes, respectively, provided on the gate insulating film. That is to say, a reticulate structure is formed by use of the common electrodes, common electrode wires and the auxiliary common electrode wires. Therefore, it is possible to have the structure close to one which a resistance is determined just by a relation of an aspect ratio (concept of sheet resistance), regardless of its size and material. Therefore, it is possible to reduce the resistance between two arbitrary points. Further, in the technique described in Patent Document 2, the common electrodes 120 and the common electrode wires 121 are connected to each other via source metals (metal layer of source bus lines) as illustrated in Fig. 27. This causes a problem of pixel defect in a case where ohmic contact cannot be made. However, the reticulate structure enables the common electrodes to have four-directional redundancy. Therefore, even if a pixel that cannot make the ohmic contact, or, further even if one of the common electrodes and/or the auxiliary common electrodes have a breakage, the pixel defect and line defect is prevented to the utmost.

The active matrix substrate of the present invention is preferably arranged such that each of the common electrodes has an opening section whose first and second end sections are located outside and inside, respectively, of an outer edge of a respective one of the contact holes; and contact electrode pads connected to (i) the auxiliary common electrode wires on the first end sections side of the common electrodes, and (ii) the common electrodes on the second end sections side of the common electrodes, respectively.

According to the arrangement, each of the common electrodes has an opening whose first and second end sections are located outside and inside, respectively, of an outer edge of a respective one of the contact holes, and contact electrode pads are connected to (i) the auxiliary common electrode wires on the first end sections side of the common electrodes, and (ii) the common electrodes on the second end sections side of the common electrodes, respectively. This allows electrical connection between the common electrodes and the auxiliary common electrode wires by use of the contact electrode pads. Moreover, this allows elimination of a contact hole forming step for connecting the common electrodes and the auxiliary common electrode wires, which forming step is to be carried out before formation of the source wires/electrodes and the drain electrodes.

The active matrix substrate of the present invention is preferably arranged such that the pixel areas include pixel electrodes, and the contact electrode pads are formed to be made of a same material and in a same manufacturing step as the pixel electrodes.

According to the arrangement, pixel electrodes and contact pads are formed by a same material and in a same manufacturing step. This allows simplification of a manufacturing method.

The active matrix substrate of the present invention is preferably arranged such that the auxiliary common electrode wires are provided substantially mid between adjacent ones of the scanning signal lines, respectively.

According to the arrangement, the auxiliary common electrode wires are provided substantially mid between adjacent ones of the scanning signal lines. The auxiliary common electrode wires are provided parallel to the scanning signal lines. Therefore, by providing the auxiliary common electrode wires substantially mid between the adjacent ones of the scanning signal lines, a distance between the auxiliary common electrode wires and the scanning signal lines is maximized. A longer distance from the auxiliary common electrode wires to the scanning signal line reduces a possibility of a shortage in the auxiliary common electrode wires and the scanning signal lines due to poor patterns and adherence of dust.

The active matrix substrate of the present invention is preferably arranged such that the auxiliary common electrode wires are provided in a vicinity of one of adjacent ones of the scanning signal lines.

According to the arrangement, the auxiliary common electrode wires are provided in a vicinity of one of the adjacent ones of the scanning signal lines. In the vicinity of the scanning signal lines is an area that does not contribute to an aperture. Therefore, it is possible to realize a high aperture ratio since parts of the auxiliary common electrode wires are provided on the area which does not contribute to the aperture.

The active matrix substrate of the present invention is preferably arranged such that the auxiliary common electrode wires extend to outer peripheral sections of the common electrodes, and extend in the outer peripheral sections so as to be parallel to the video signal lines, respectively.

The outer peripheral section of the common electrode has a so-called disabled area (an area in which liquid crystal does not move, and a liquid crystal domain occurrence area). According to the present invention, the auxiliary common electrode wires extend to the outer peripheral section of the common electrodes and extend in the outer peripheral sections so as to be parallel to the video signal lines, respectively. Therefore, light shielding of the disabled area is carried out by the auxiliary common electrode wires, therefore allows attainment of a high display quality.

The active matrix substrate of the present invention is preferably arranged such that the auxiliary common electrode wires also extend to the outer peripheral sections of the common electrodes, and extend in the outer peripheral sections so as to be parallel to the scanning signal lines, respectively.

According to the arrangement, it is possible to reduce resistance of the auxiliary common electrode wires and shield light from the disabled area of the scanning signal lines.

The active matrix substrate of the present invention is preferably arranged such that a metal layer is provided so as to surround outer peripheries of the common electrodes, the metal layer being stacked to be used as an upper layer of the source electrodes and the drain electrodes.

According to the arrangement, a metal layer stacked to be used as an upper layer of the source electrodes and the drain electrodes is provided so as to surround outer peripheries of the common electrodes. This allows the outer peripheries of the common electrodes to have a light shielding function, and the resistance between the common electrodes and the auxiliary common electrode wires is reduced.

The active matrix substrate of the present invention is preferably arranged such that the metal layer is formed on parts on which the common electrode wires are provided.

In addition, the active matrix substrate of the present invention is preferably arranged such that a metal layer is provided on intersections of the common electrode wires and the scanning signal lines.

According to the arrangement, a metal layer is provided on intersections of the common electrode wires and the scanning signal lines. Therefore, it is possible to reduce the resistance of the common electrode wires. Further, the common electrode wires are of a stacked structure having the transparent electrode layer and the metal layer. This enables reduction of malfunction in the intersecting section with the scanning signal line such as breakage.

The active matrix substrate of the present invention further preferably includes an interlayer insulating film including at least two layers, the two layers being a layer composed of an inorganic film and a layer composed of a low dielectric constant organic material.

Here, low dielectric constant organic material denotes for example material having a dielectric constant of not more than 5. According to the arrangement, an interlayer insulating film includes at least two layers, a layer composed of inorganic film and a layer composed of low dielectric constant organic material. Providing the low dielectric constant organic material allows decreasing of the parasitic capacitance. Further, by arranging the interlayer insulating film as having at least two layers, defects such as leakage is reduced. As a result, high reliability is realized.

A liquid crystal display device of the present invention preferably includes any one of the foregoing active matrix substrates.

For a fuller understanding of the nature and advantages of the invention, reference should be made to the ensuing detailed description taken in conjunction with the accompanying drawings.

### BRIEF DESCRIPTION OF DRAWINGS

Fig. 1 is a cross sectional view illustrating one pixel area of an active matrix substrate of an embodiment in the present invention, wherein (a) is a cross sectional view taken on a line A-A' as indicated in Fig. 2, and (b) is a cross sectional view taken on a line B-B' as indicated in Fig. 2.
Fig. 2 is a plane view illustrating one pixel area in an active matrix substrate of the present embodiment.
Fig. 3 is a cross sectional view illustrating a manufacturing process of the active matrix substrate of an embodiment in the present invention, wherein (a) through (i) are cross sectional views illustrating a manufacturing process of the active matrix substrate illustrated in (a) of Fig. 1.
Fig. 4 is a cross sectional view illustrating a first modification of the embodiment, wherein (a) is a cross sectional view corresponding to the line A-A' in (a) of Fig. 1, and (b) is a cross sectional view corresponding to the line B-B' in (b) of Fig. 1.
Fig. 5 illustrates an embodiment of the present invention, and is a plane view of a second modification, corresponding to Fig. 2.
Fig. 6 is a cross sectional view illustrating the second modification of the embodiment in the present invention, wherein (a) is a cross sectional view taken on a line A-A' as indicated in Fig. 5, and (b) is a cross sectional view taken on a line B-B' as indicated in Fig. 5.
Fig. 7 illustrates an embodiment of the present invention, and illustrates a plane view of a third modification, corresponding to Fig. 2.
Fig. 8 is a cross sectional view illustrating a third modification of the embodiment in the present invention, wherein (a) is a cross sectional view taken on a line A-A' as indicated in Fig. 7, and (b) is a cross sectional view taken on a line B-B' as indicated in Fig. 7.
Fig. 9 illustrates an embodiment of the present invention, and is a plane view of a fourth modification, corresponding to Fig. 2.
Fig. 10 is a cross sectional view illustrating the fourth modification of the embodiment in the present invention, wherein (a) is a cross sectional view taken on a line A-A' as indicated in Fig. 9, and (b) is a cross sectional view taken on a line B-B' as indicated in Fig. 9.
Fig. 11 illustrates an embodiment of the present invention, and is a plane view of a fifth modification, corresponding to Fig. 2.
Fig. 12 illustrates an embodiment of the present invention, and is a cross sectional view taken on a line A-A' as indicated in Fig. 11.
Fig. 13 illustrates an embodiment of the present invention, and is an enlarged view of a section C illustrated in Fig. 3, that is, an intersecting section of a common electrode and auxiliary common electrode wires.
Fig. 14 illustrates an embodiment of the present invention, and is a cross sectional view taken on a line B-B' as indicated in Fig. 13.
Fig. 15 is a cross sectional view illustrating a manufacturing process of an active matrix substrate of an embodiment in the present invention, wherein (a) through (i) illustrates cross sectional views of a manufacturing process of the active matrix substrate illustrated in Fig. 12.
Fig. 16 illustrates an embodiment of the present invention, and is a cross sectional view and a plane view illustrating a formation method of a contact section in a six-mask process, wherein (a) through (e) are cross sectional views, and (f) through (j) are plane views.
Fig. 17 illustrates an embodiment of the present invention, and is a cross sectional view and a plane view illustrating a formation method of a contact section in a five-mask process, wherein (a) through (e) are cross sectional views, and (f) through (j) are plane views.
Fig. 18 is a plane view and a cross sectional view of a comparative example of Figs. 13 and 14 that illustrate an embodiment of the present invention, wherein (a) is a plane view, and (b) is a cross sectional view.
Fig. 19 is a plane view and a cross sectional view of a comparative example of Figs. 13 and 14 that illustrate an embodiment of the present invention, wherein (a) is a plane view, and (b) is a cross sectional view.
Fig. 20 is a plane view of a sixth modification of the embodiment in the present invention, wherein (a) and (b) are plane views illustrating the sixth modification, corresponding to Fig. 2.
Fig. 21 is a plane view and a cross sectional view of an active matrix substrate used in a conventional liquid crystal display device of an FFS mode, wherein (a) is a plane view of the active matrix substrate used in the conventional liquid crystal display device of the FFS mode, and (b) is a cross sectional view taken on a line A-A' as indicated in (a).
Fig. 22 is a cross sectional view of an active matrix substrate illustrating a conventional state in which a common electrode and a gate bus line upper layer is roughened.
Fig. 23 is a cross sectional view illustrating a conventional state in which a gate insulating film is not capable of covering gate bus lines, caused by the gate bus lines being back tapered (peaked).
Fig. 24 is a plane view of an LCD panel illustrating a conventional position of common electrode wires.
Fig. 25 is a cross sectional view illustrating a conventional active matrix substrate.
Fig. 26 is a cross sectional view illustrating a conventional active matrix substrate.
Fig. 27 is a cross sectional view illustrating a conventional active matrix substrate.

### REFERENCE NUMERALS

- 1: insulating substrate
- 2: gate wires, gate (scanning signal lines; gate electrode, metal film formed so as to form the gate electrodes)
- 3: auxiliary common electrode wires
- 4: gate insulating film
- 5: contact hole (formed so as to connect the common electrode to the auxiliary common electrode wires)
- 5': contact hole (formed so as to connect the common electrode to the auxiliary common
- 8a: electrode wires) source wires, source (video signal lines; source electrode)
- 8b: common electrode wires
- 9: common electrode
- 10: drain (drain electrode)
- 12: contact hole (formed so as to connect a drain electrode and a pixel electrode)
- 17: contact electrode pad
- 18: TFT (thin film transistor)
- 19: transparent conductive film (transparent electrode layer)
- 21: metal layer (metal layer that is stacked so as to be used as an upper layer of the source electrode and drain electrode)
- 22: metal layer
- 23: inorganic film
- 24: film made of low dielectric constant organic material (layer composed of low dielectric constant organic material)
- 25: light shielding film (metal layer provided so as to surround outer peripheries of the common electrodes)

### BEST MODE FOR CARRYING OUT THE INVENTION

One embodiment of the present invention is described below with reference to the attached drawings.

### (Arrangement of Active Matrix Substrate)

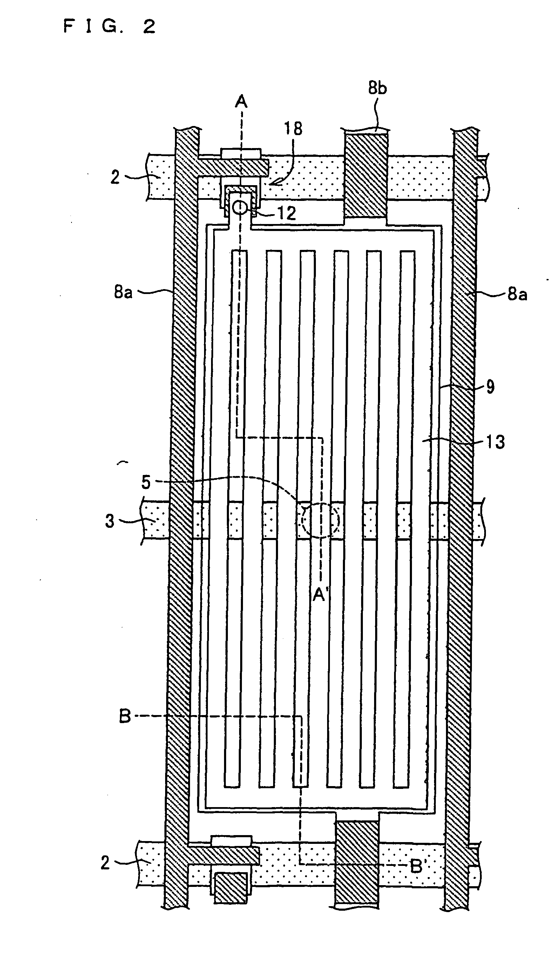

Fig. 2 is a plane view illustrating one pixel area of an active matrix substrate of the present embodiment.

An active matrix substrate of the present embodiment includes: a plurality of source wires 8a and a plurality of gate wires (scanning signal lines) 2, a plurality of rectangular-shaped (straight comblike) pixel electrodes 13, common electrodes 9, common electrode wires 8b, auxiliary electrode wires 3, and TFTs (Thin Film Transistor) 18, as illustrated in Fig. 2. The plurality of source wires 8a and the plurality of gate wires 2 orthogonally intersect with each other. Each of the plurality of rectangular-shaped pixel electrodes 13 is provided parallel to the source wires (video signal lines) 8a in areas (pixel areas; later described) surrounded by the source wires 8a and the gate wires 2. Each of the common electrodes 9 is provided under the pixel electrodes 13. The common electrode wires 8b extend in a parallel direction to the source wires 8a from the common electrodes 9. Each of the auxiliary common electrode wires 3 are provided parallel to the gate wires 2 between adjacent gate wires 2. The TFTs 18 serves as a switching element.

In the present specification, an area surrounded by two adjacent source wires 8a and two adjacent gate wires 2 is called a pixel area. Moreover, each of the common electrode wires 3 are provided between respective two adjacent gate wires 2, as illustrated in Fig. 2.

For convenience, in the following description, sources (source electrode) which form the TFTs 18 and gates (gate electrode) which also form the TFTs 18 are given identical reference numerals as the source wires and the gate wires, respectively.

In the present embodiment, the common electrodes 9 are provided in the pixel areas, and the common electrode wires 8b are provided parallel to the source wires 8a so as to connect adjacent ones of the common electrodes 9. Further, the auxiliary common electrode wires 3 that are connected to the common electrodes 9 via contact holes are provided parallel to the gate wires 2.

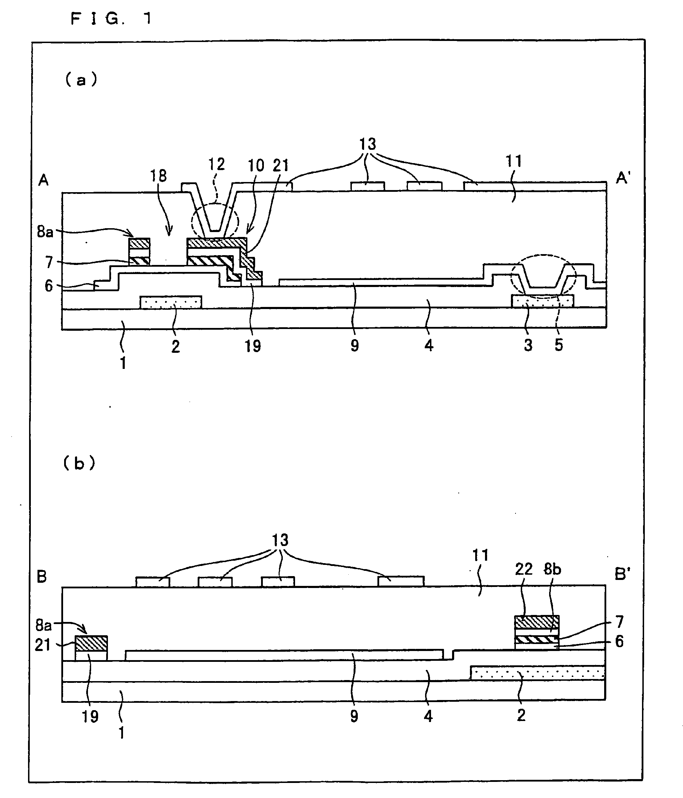

The common electrodes 9 and the auxiliary common electrode wires 3 intersect in the pixel areas, and on the common electrodes 9 at these intersections, contact holes 5 are provided (see (a) of Fig. 1). On the other hand, contact holes 12 are provided on the pixel electrodes 13 so as to connect the pixel electrodes 13 to respective TFTs 18 (see (a) of Fig. 1). Note that the contact holes 5 are not necessarily provided in all of the pixel areas, and may be provided in pixel areas alternately skipped by one or two pixel areas.

(a) of Fig. 1 is a cross sectional view taken on a line A-A' as indicated in Fig. 2. This cross section taken on the line A-A' illustrates a cross section from the TFT 18 to the intersecting section of the common electrode 9 and the auxiliary common electrode wires 3.

As illustrated in (a) of Fig. 1, an insulating substrate 1 is provided as the bottommost layer of the active matrix substrate, and on the insulating substrate 1, the gate 2 and the auxiliary common electrode wires 3 are provided spaced apart from each other. An a-Si layer 6 and an n⁺-Si layer 7 are formed on the gate 2 in this order, having a gate insulating film 4 sandwiched between the gate 2 and the a-Si layer 6. The a-Si layer 6 and the n⁺-Si layer 7 construct a channel section. Further, a source 8a and a drain (drain electrode) 10, each of which construct the TFT 18, are formed on the channel section. In the present embodiment, the source 8a and the drain 10 include a transparent conductive film (ITO) 19 and a metal layer 2 so as to be of a double-layered structure as illustrated in (a) of Fig. 1, which transparent conductive film (ITO) 19 serves as a lower layer and metal layer 21 serves as an upper layer. Further, the metal layer 21 as the upper layer of the drain 10 is connected to the pixel electrodes 13 via the contact hole 12. In addition, an interlayer insulating film 11 is provided on an upper surface of the metal layer 21 on a position other than the contact hole 12.

On the other hand, the gate insulating film 4 and the common electrode 9 are provided on the auxiliary common electrode wires 3 in this order. The auxiliary common electrode wires 3 and the common electrode 9 are connected to each other via the contact hole 5. Particularly, as obvious from (a) of Fig. 1, a layer arranged on a same layer as the transparent conductive film (ITO; transparent electrode layer) which is the lower layer of the source 8a and the drain 10 serves as the common electrode 9. The pixel electrodes 13 are provided on the common electrode 9 via the interlayer insulating film 11. The interlayer insulating film 11 is composed of an inorganic film made of such as SiNx, SiO₂ and the like.

(b) of Fig. 1 is a cross sectional view taken on a line B-B' as indicated in Fig. 2. The cross section taken on the line B-B' illustrates a cross section from the source wires 8a to the intersecting section of the gate wires 2 and the common electrode wires 8b, passing through the pixel area.

As illustrated in (b) of Fig. 1, the insulating substrate 1, the gate insulating film 4, the source wires 8a, and the interlayer insulating film 11 are provided in an area corresponding to the source wires 8a in this order. The source wires 8a are of a double-layered structure having the transparent conductive film (ITO) 19 as the lower layer and the metal layer 21 as the upper layer. In the pixel area, the insulating substrate 1, the gate insulating film 4, the common electrode 9, the interlayer insulating film 11, and the pixel electrodes 13 are provided in this order. Further, in an area corresponding to the intersecting section of the gate wires 2 and the common electrode wires 8b, the insulating substrate 1, the gate wires 2, the gate insulating film 4, the a-Si layer 6, the n⁺-Si layer 7, the common electrode wires 8b, the metal layer 22, and the interlayer insulating film 11 are provided in this order.

Note that, as obvious from Fig. 2 and (b) of Fig. 1, the metal layer 22 is provided on the intersecting section of the common electrode wires 8b and the gate wires 2.

### (Method for Manufacturing Active Matrix Substrate)

The following description explains a method for manufacturing the active matrix substrate. This method for manufacturing the active matrix substrate uses six masks. However, the auxiliary common electrode wires 3 are not essential in the arrangement. Therefore, in a case where the auxiliary common electrode wires 3 are not provided, a step for forming the contact hole 5 is unnecessary. As a result, the active matrix substrate can be manufactured by use of five masks.

### (Step 1)

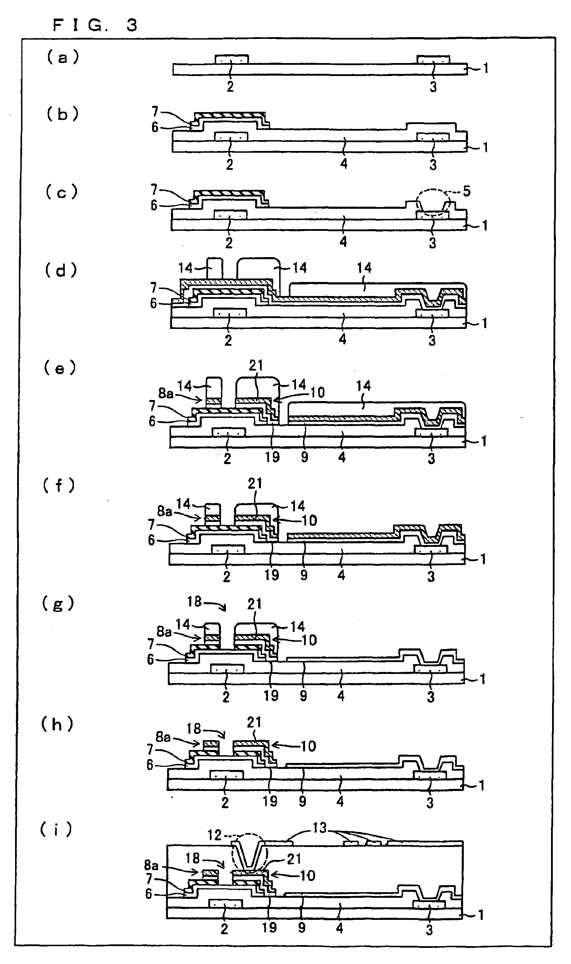

As illustrated in (a) of Fig. 3, a film is formed on the insulating substrate 1 by sputtering Ti/Al/Ti or the like in a thickness of approximately 250 nm. Thereafter, by a photolithography method, the gate 2 and the auxiliary common electrode wires 3 are formed spaced apart from each other. In this step 1, a first mask is to be used.

### (Step 2)

By a plasma CVD (chemical vapor deposition) method, the gate insulating film (silicon nitride; SiNx) 4, the a-Si layer 6, and the n+-Si layer 7 are formed consecutively in this order having a thickness of approximately 300 nm, 150 nm, and 50 nm, respectively. After formation of the films, positions corresponding to the gate 2 and the auxiliary common electrode wires 3 are patterned as an island-shape by the photolithography method, as illustrated in (b) of Fig. 3. Note that a channel section of the TFT 18 is still not formed at this point. In the step 2, a second mask is to be used.

### (Step 3)

The gate insulating film 4 provided on the auxiliary common electrode wires 3 is etched in a predetermined pattern by the photolithography method as illustrated in (c) of Fig. 3, so as to form the contact hole 5 and a wires lead-out terminal pad section (not illustrated) of the gate wires 2 and the source wires 8b. In the step 3, a third mask is to be used.

### (Step 4)

A transparent conductive layer made of ITO is formed as a lower layer having a thickness of approximately 100 nm, and a metal layer made of Mo/Al/MoN or the like is formed as an upper layer having a thickness of approximately 150 nm, consecutively, by sputtering. Following formation of the film, a photoresist 14 is formed as illustrated in (d) of Fig. 3. The photoresist 14 causes, by a halftone exposure method, a remaining amount of photoresist on the film in (i) an area in which the transparent conductive film and the metal layer are both to be removed, (ii) a first area (an area forming the source 8a or the drain 10) in which the transparent conductive film and the metal layer are both to remain, and (ii) a second area (an area forming the common electrode 9) in which the transparent conductive film and the metal layer are both to remain, to be approximately 0 nm, 3000 nm, and 1000 nm, respectively. Although not illustrated in the drawings, the photoresist 14 that causes a film to remain by an amount of approximately 3000 nm is also formed on an area on which the common electrode wires 8b are to be formed. In this step, a fourth mask is to be used.

### (Step 5)

The metal film is etched by a wet etching method by use of a wet etching liquid containing a phosphoric acid - hydrochloric acid - nitric acid type etching liquid. Further, the transparent conductive film is etched by a wet etching method by use of a ferric chloride etchant. This forms the source 8a and the drain 10, as illustrated in (e) of Fig. 3.

The source 8a and the drain 10 are formable as a double-layered structure by carrying out this step, having the transparent conductive film (ITO) 19 as a lower layer and the metal layer 21 as an upper layer. Further, the common electrode 9 is simultaneously formed.

Furthermore, a point that is to be particularly noted in this step and in Step 4 is that, a bottommost layer of the source 8a and the drain 10 is the transparent conductive film (ITO) 19, and that this bottommost layer being the transparent conductive film (ITO) 19 also serves as the common electrode 9.

Note that although not illustrated in the drawings, the common electrode wires 8b is also formed in this step.

### (Step 6)

The photoresist 14 provided on the area on which the common electrode 9 is formed is removed by a dry etching method utilizing a gas containing O₂, as illustrated in (f) of Fig. 3.

### (Step 7)

As illustrated in (g) of Fig. 3, the metal film on the area on which the common electrode 9 is formed is removed by the wet etching method utilizing the phosphoric acid - hydrochloric acid - nitric acid type etching liquid. Thereafter, a channel section including the a-Si layer 6 and the n⁺-Si layer 7 is formed by the dry etching method utilizing a gas containing SF₆. This forms, for each pixel, a TFT 18 which serves as a switching element.

### (Step 8)

The photoresist on the area on which the source 8a, the common electrode wires 8b, and the drain 10 are formed is removed by the dry etching method utilizing the gas containing O₂, as illustrated in (h) of Fig. 2.

Note that, although not illustrated in the drawing, the photoresist on the area on which the common electrode wires 8b is formed is simultaneously removed.

### (Step 9)

A silicon nitride film is formed in a thickness in a range of approximately 250 nm to 500 nm so as to serve as the interlayer insulating film 11, by the plasma CVD method. This interlayer insulating film 11 is then etched in a predetermined pattern by the photolithography method so as to form the contact hole 12 and the wires lead-out terminal pad section (not illustrated) of the gate wires 2 and source wires 8a. Following this, the transparent conductive film made of ITO is formed by sputtering in a thickness of approximately 100 nm on the interlayer insulating film 11. Thereafter, the pixel electrodes 13 are etched in a predetermined pattern (by use of a sixth mask). This concludes the formation of the active matrix substrate illustrated in (a) of Fig. 1.

As described above, the active matrix substrate of the present embodiment has a wiring structure in which the source/drain electrodes have transparent electrodes as the bottommost layer, and further has the transparent electrodes that are the bottommost layer to serve as a common electrode, as illustrated in (a) of Fig. 1. In the present embodiment, the common electrodes are provided on the bottommost layer of the source electrodes/wires and the drain electrodes/wires, and not the ITO (common electrode) serving as a bottommost layer of the gate electrodes/wires. Conventionally, the ITO is provided parallel to the gate electrode/wires.

In comparison, the present embodiment forms the source electrodes/wires 8a and the drain electrodes/wires 10 by use of a transparent conductive film (ITO) 19 and an opaque metal layer 21 provided on the ITO 19 as an upper layer of the ITO 19. This allows leading out of the common electrode wires 8b formed by the ITO 19 parallel to the source wires.

If the ITO is provided on the bottommost layer of the gate electrodes/wires as with a conventional active matrix substrate, a problem occurs that the gate electrodes/wires roughens since an amorphous silicon on a gate insulating film is positioned on an upper side of the ITO. If the gate electrodes/wires roughens, the flatness decreases and the roughness of the TFT channel section increases. This causes a decrease in mobility. In comparison, the present embodiment does not provide the ITO on the bottommost layer of the gate electrodes/wires. Thus, it is possible to avoid the problem of the amorphous silicon to roughen.

Further, the ITO has an extremely low transition temperature of crystallization in a case where the ITO is provided on the bottommost layer of the gate electrodes/wires as with the conventional active matrix substrate. That is to say, the ITO polysiliconizes from an amorphous state at around a temperature in a range of 150 ° to 200 °. When the transparent electrodes are compared between a crystallized state and the amorphous state, a large difference is recognized in an etching rate. Therefore, polysiliconization of the transparent electrodes cause a need to etch for a remarkably long period of time. In other words, over-etching is necessarily carried out. As a result, the gate wires become back tapered (peaked), which causes a problem that the gate insulting film cannot be covered. On the other hand, with the present embodiment, the ITO is not provided on the bottommost layer of the gate electrodes/wires. As a result, it is possible to avoid such problem.

As described above, the ITO is provided as the bottommost layer of the source electrodes/wires and the drain electrodes/wires. Further, it is arranged such that the common electrode wires formed by the ITO be lead out parallel to the source wires. Generally, the source wires are shorter than the gate wires. For example, in a case of an XGA standard, a number of wires is 768 x 1024 (D x W). Therefore, an aspect ratio of the display section is 3 : 4. Further, in a case of a full HD standard that is adopted in large-screen televisions, the number of wires is 1080 x 1920 (D x W), and the aspect ratio of the display screen is 9 : 16.

As a result, signal delay caused by resistance is reduced in wires that are parallel to the source wires, as compared to wires that are parallel to the gate wires.

Further, the present embodiment has the auxiliary common electrode wires 3 provided parallel to the gate electrode/wires 2 between adjacent gate electrode/wires 2, in addition to the common electrode wires 8b provided parallel to the source wires/electrode 8a. That is to say, common electrode wires are reticulately provided, by connection of the wires. This thus allows having an arrangement in which resistance is determined just by relation of the aspect ratio, regardless of a size of a display section. As a result, the resistance between two arbitrary points is reduced. In addition, reticulately providing the common electrode wires allows having redundancy in four directions.

As illustrated in (b) of Fig. 1, the metal layer 22 is provided as an upper layer of the common electrode 8b in an area corresponding to the intersecting section of the gate electrodes/wires 2 and the common electrode wires 8b. The intersecting section has narrow common electrode wires 8b. Therefore, breaking of the wires may readily occur, and a loss due to resistance is great. In comparison, as described above, the common electrode wires 8b having the metal layer 22 as the upper layer of the common electrode wires 8b secures connection at the metal layer even if breaking of the wires occur under the metal layer. In addition, the loss due to the resistance is suppressed by having a low resistant metal layer 22 stacked on the common electrode wires 8b.

Further, as illustrated in (b) of Fig. 1, in the area corresponding to the intersecting section of the gate electrodes/wires 2 and the common electrode wires 8b, a semiconductor layer including the a-Si layer 6 and the n⁺-Si layer 7 is provided. Therefore, it is possible to (i) have a reasonable distance between the gate electrodes/wires 2 and the common electrode wires 8b and (ii) reduce a capacitance between the gate electrodes/wires 2 and the common electrode wires 8b, as compared to an arrangement that does not provide the semiconductor layer.

The common electrode wires 3 are provided mid between two respective adjacent gate electrodes/wires 2, as illustrated in Fig. 2. This allows providing a reasonable distance between the common electrode wires 3 and the gate electrodes/wires 2. Consequently, it is possible to reduce the possibility of shortage between the common electrode wires 3 and the gate electrodes/wires 2 caused by poor patterning and adhering of dust.

The following description explains modifications of the embodiment. In the modifications explained below, explanations of common points with the foregoing embodiment are omitted, and identical reference numerals are used. For convenience, the foregoing embodiment is denoted as representative example.

### (First Modification)

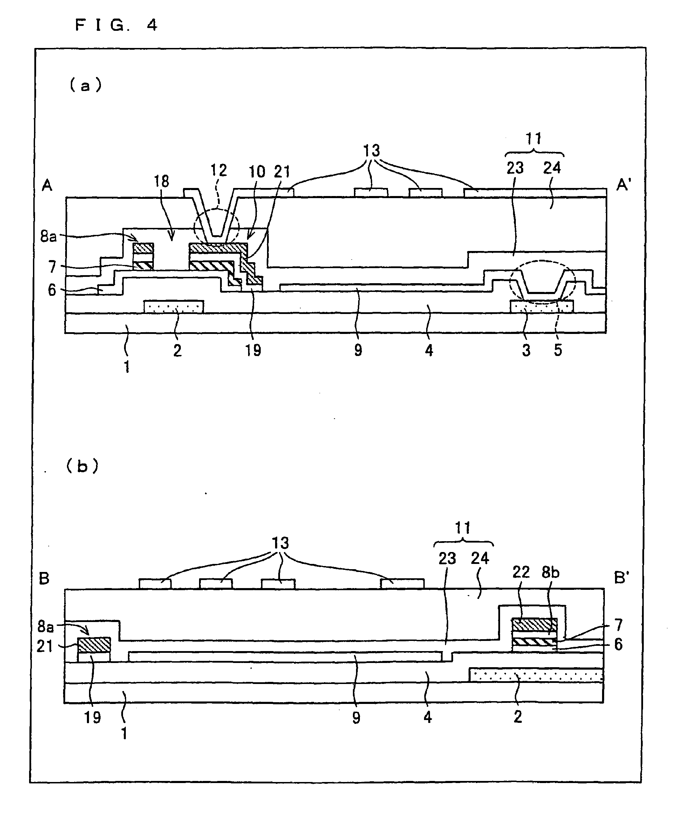

Fig. 4 illustrates First Modification, wherein (a) is a cross sectional view taken on a line A-A' corresponding to (a) of Fig. 1, and (b) is a cross sectional view taken on a line B-B' corresponding to (b) of Fig. 1. A plane view of the First Modification is identical to Fig 2. Therefore, the plane view of the First Modification is omitted here.

The representative example has a single-layered interlayer insulating film 11 as illustrated in (a) and (b) of Fig. 1. In comparison, the First Modification has a double-layered interlayer insulating film 11, as illustrated in (a) and (b) of Fig. 4. More specifically, in the First Modification, the interlayer insulating film 11 is so arranged as a double-layered structure including an inorganic film 23 made of SiNx, SiO₂ or the like, and a film 24 made of low-dielectric constant organic material.

This allows reduction of parasitic capacitance as compared to the representative example. Further, defect such as leakage is reduced as compared to the representative example. Therefore, a high reliability is realizable.

The following is an explanation of a reason why the defect such as the leakage is reduced in the First Modification. In an arrangement in which two layers of metal layers sandwich a single-layered insulating film, a pinhole or a defect in the single-layered insulting film causes a leakage in the upper and the lower metal layers. Further, with this arrangement, if an echant (etching liquid) that is used for wet etching the upper metal layer can also etch the lower metal layer, the lower metal layer is etched in a case where the single-layered insulating film has the pinhole or defect. This causes breaking of wires and the like. Usually, no matter how a dust management is carried out, the insulating film has some pinhole or defect.

In response to this, a possibility of the pinhole or defect occurring at a same position in the two layers of insulating films is dramatically low as compared to a possibility of the pinhole or defect occurring to the single-layered insulating film. Therefore, it is possible to dramatically reduce the possibility of an occurrence of leakage in the upper and lower metal layers and the possibility of breakage in the lower metal layer, by having the insulating film that is sandwiched between the two metal layers be the double-layered structure, as in the arrangement of the First Modification.

Note that the First Modification is manufactured by forming, in Step 9, as the interlayer insulating film, an inorganic film made of SiNx, SiO₂ or the like in a thickness in a range of 150 nm to 350 nm, and then forming a film made of low dielectric constant organic material in a thickness in a range of 2000 nm to 4000 nm on the inorganic film.

The explanation of the First Modification describes an interlayer insulating film of a double-layered structure, however the structure of the interlayer insulating film is not limited to two layers, and may have three or more layers, by arbitrarily stacking the inorganic film 23 made of the SiNx, SiO₂ or the like and the film 24 made of low dielectric constant organic material.

### (Second Modification)

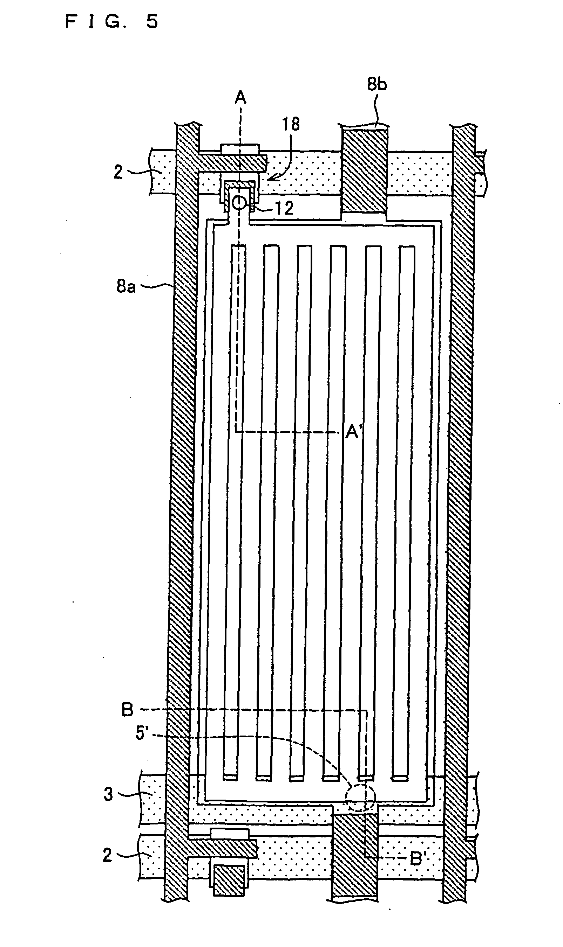

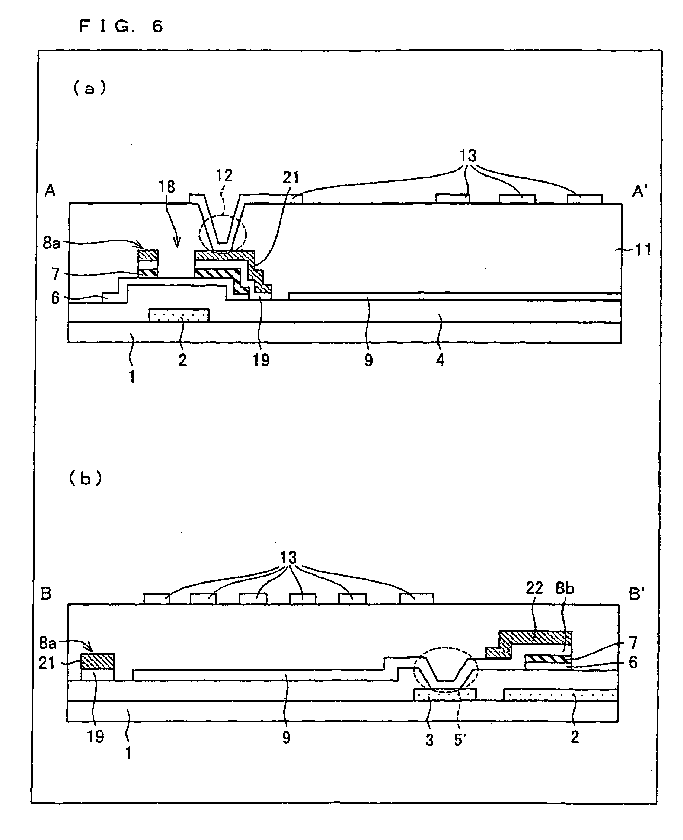

Fig. 5 illustrates Second Modification, and is a plane view corresponding to Fig. 2. In addition, (a) of Fig. 6 is a cross sectional view taken on a line A-A' as indicated in Fig. 5, and (b) of Fig. 6 is a cross sectional view taken on a line B-B' as indicated in Fig. 5.

In the representative example, the auxiliary common electrode wires 3 are arranged substantially mid between adjacent gate wires 2, respectively. In comparison, the Second Modification arranges the auxiliary common electrode wires 3 in a vicinity of one of the respective adjacent gate wires 2. More specifically, the auxiliary common electrode wires 3 has a section that does not overlap with the pixel electrodes 13 in an extending direction of the source wires 8a. That is to say, the auxiliary common electrode wires 3 juts out from the pixel electrodes 13 in the extending direction of the source wires 8a. Moreover, the Second Embodiment has a contact hole 5' at least on a part of the common electrode wires 8b.

The arrangement illustrated in the cross section taken on the line A-A' as indicated in (a) of Fig. 6, that is, the cross section including an area in which the TFT 18 is provided to around a center of the pixel area, does not include the auxiliary common electrode wires 3, as different to Fig. 2(a). On the other hand, the arrangement illustrated in the cross section taken on the line B-B' as indicated in (b) of Fig. 6, that is, the cross section including the area corresponding to the gate wires 2 to the area corresponding to the intersecting section of the gate wires 2 and the common electrode wires 8b via the pixel area includes the auxiliary common electrode wires 3 provided in the pixel area, as different to Fig. 2(b). The auxiliary common electrode wires 3 and the common electrodes 9 (including parts of the common electrode wires 8b) are connected via the contact hole 5' formed on a position in which a part overlaps with the area of the common electrode wires 8b.

This allows partial arrangement of the auxiliary electrode wires 3 on a section which does not contribute to an aperture. That is, it is possible to reduce a disabled area (area in which liquid crystal does not move, and a liquid crystal domain area). Therefore, a high aperture ratio is realized.

The following description specifically explains a reason why this high aperture ratio is realized. First, the disabled area is defined. The disabled area denotes areas of the following (A) through (D):
(A) A part in which the auxiliary common electrode wires 3 are provided;
(B) At least both edges (parts of which the comblike teeth of the pixel electrodes are bundled and connected) of the pixel electrodes 13 that are parallel to the source wires 8a, among parts of the common electrodes 9 and the pixel electrodes 13 which overlap with each other;
(C) Other gaps between the gate electrodes/wires 2 and the auxiliary common electrode wires 3, and gaps between the source wires 8a and the common electrode 9 (although dependent on a design rule); and
(D) A disabled area generated due to an oriented state of the liquid crystal.

In the representative example, the disabled area is (A) + (B) + (C) + (D). On the other hand, in the Second Modification, a portion of the areas (B) and (C) overlap with the area (A), therefore the disabled area is the area excluding the overlapping portions of the disabled areas (B) and (C) with area (A). As a result, the disabled area is reduced in the Second Modification as compared to the representative example. This allows realization of the high aperture ratio.

The Second Modification is manufactured by changing, in Step 1, a provided position of the auxiliary common electrode wires 3 to a position closer to the gates 2.

Note that the positioning of the auxiliary common electrode wires 3 in the representative example is simply one example, and may be in any position as long as the auxiliary common electrode wires 3 are positioned between two adjacent gate wires 2.

### (Third Modification)

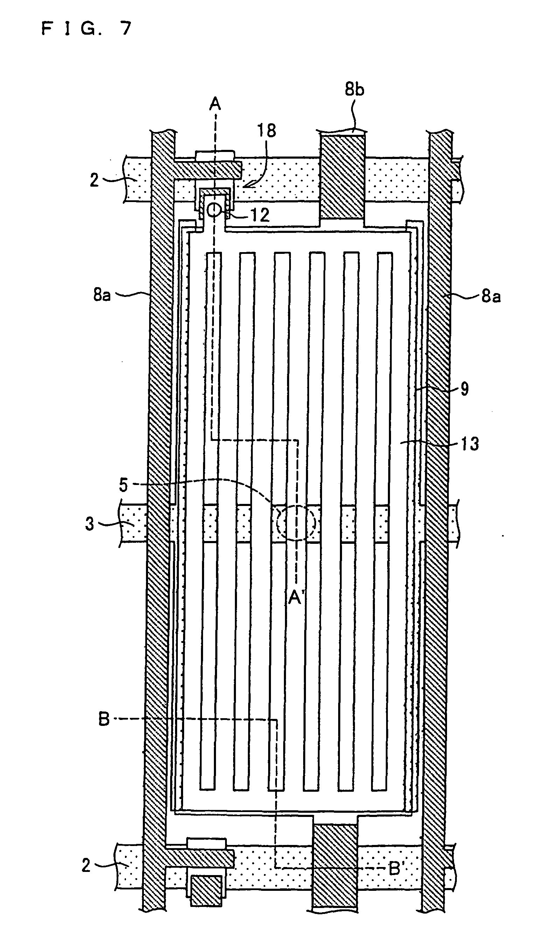

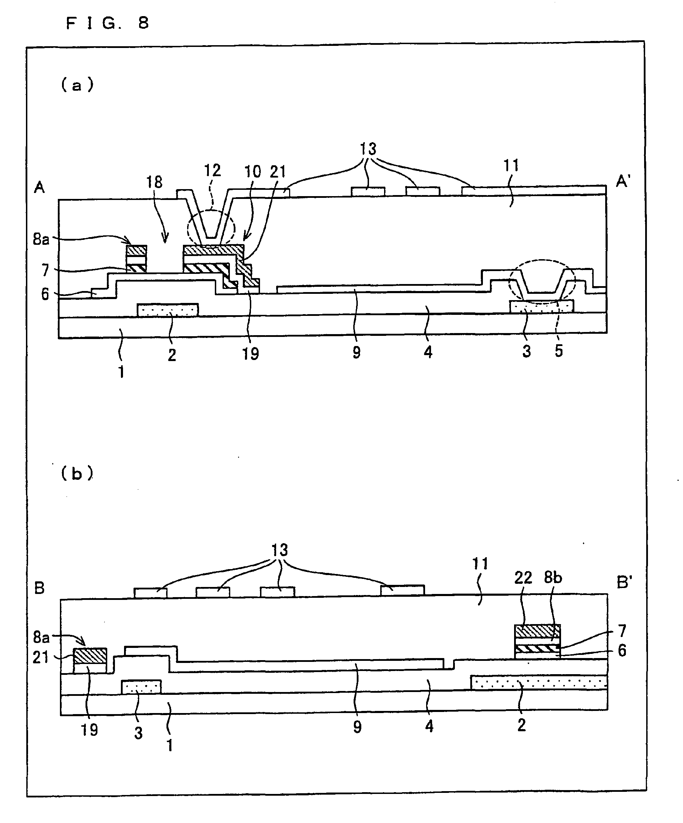

Fig. 7 illustrates Third Modification, and is a plane view corresponding to Fig. 2. In addition, (a) of Fig. 8 is a cross sectional view taken on a line A-A' as indicated in Fig. 7, and (b) of Fig. 8 is a cross sectional view taken on a line B-B' as indicated in Fig. 7.

The Third Modification, in addition to the arrangement of the representative example, has the auxiliary common electrode wires 3 extend to an outer peripheral section (disabled area) of the pixel area, and extend in the outer peripheral section so as to be parallel to the source wires 8a, as illustrated in Fig. 7. In other words, the auxiliary common electrode wires 3 are extended to a surrounding section (outer peripheral section) of the common electrodes 9, and extended in the surrounding section so as to be parallel to the source wires 8a. Namely, as illustrated in Fig. 7, a shape of the auxiliary common electrode wires 3 from a plane view is in an H-shape.

The cross section of (a) of Fig. 8 taken on the line A-A' does not pass through characteristic parts of the Third Modification, therefore is identical to (a) of Fig. 2. As illustrated in (b) of Fig. 8 of the cross section taken on the line B-B', the auxiliary common electrode wires 3 is provided on the insulating substrate 1 in the disabled area (area in which liquid crystal does not move, and liquid crystal domain occurrence area) on the source wires 8a side of the pixel areas. Therefore, light shielding of the disabled area is possible without the need to add any processes to the representative example. This allows attainment of a high display quality. The Third Modification is manufactured by forming, in Step 1, the auxiliary common electrode wires 3 parallel to the source wires 8a in the disabled area on the source wires 8a side of the pixel areas.

Further, the auxiliary common electrode wires 3 may be provided so as to extend to the outer peripheral section of the pixel area, and extend in the outer peripheral section so as to be parallel to the source wires 8a, and also extend in the outer peripheral section so as to be parallel to the gate wires 2, so as to surround the entire outer peripheral section of the pixel areas. That is to say, the common electrode wires 3 may be provided in a ring shape.

### (Fourth Modification)

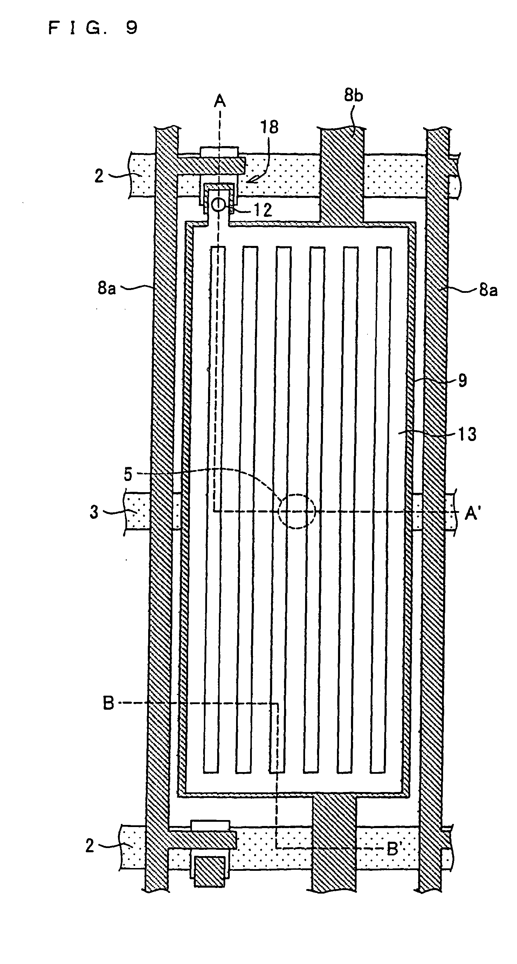

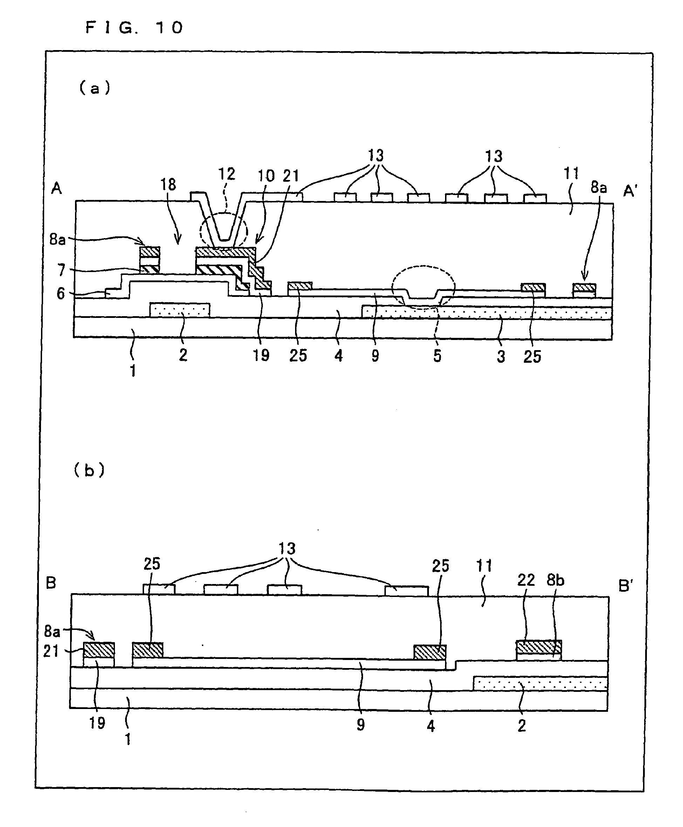

Fig. 9 illustrates Fourth Modification, and is a plane view corresponding to Fig. 2. In addition, (a) of Fig. 10 is a cross sectional view taken on a line A-A' as indicated in Fig. 9, and (b) of Fig. 10 is a cross sectional view taken on a line B-B' as indicated in Fig. 9.

In the Fourth Modification, a same metal layer as the metal layer 21 which is provided as the upper layer of the source 8a and the drain 10 is provided as a light shielding film (metal layer provided so as to surround outer peripheries of the common electrodes) 25 so as to shield a liquid crystal domain, at a surrounding section (outer peripheral section) of the common electrodes 9, as illustrated in Fig. 9, and (a) and (b) of Fig. 10. The light shielding film 25 may be provided so as to cover the entire common electrode wires 8b, as illustrated in Fig 9. The metal layer used for the light shielding film 25 is not limited to ones that have a function of a light shielding film. Namely, the light shielding function is simply one example.

The light shielding film 25 is formed by not removing all of a metal film corresponding to a position on which the common electrodes 9 are to be formed but have the metal film remain on the surrounding section of the common electrodes 9, when removing the metal film in Step 7.

The arrangement allows surroundings of the common electrodes 9 to have a light shielding function, and allows reduction of a resistance of the common electrodes 9 and the auxiliary common electrode wires 3, by providing the light shielding film 25 that is made of a low resistance metal layer.

### (Fifth Modification)

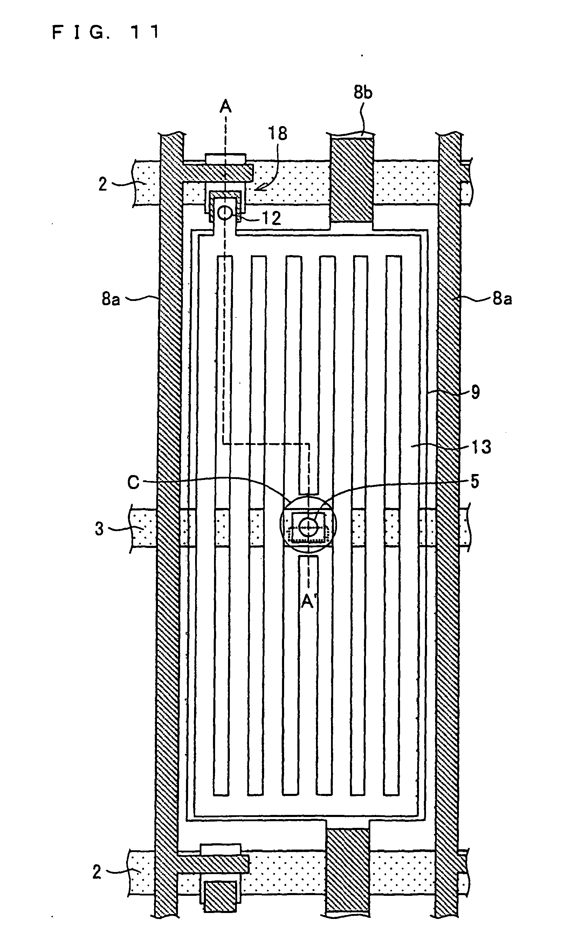

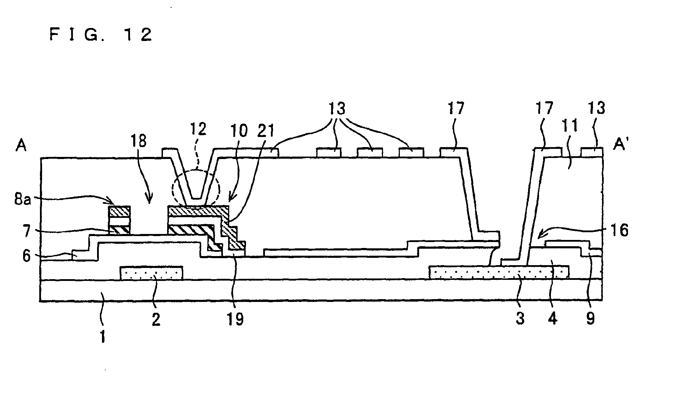

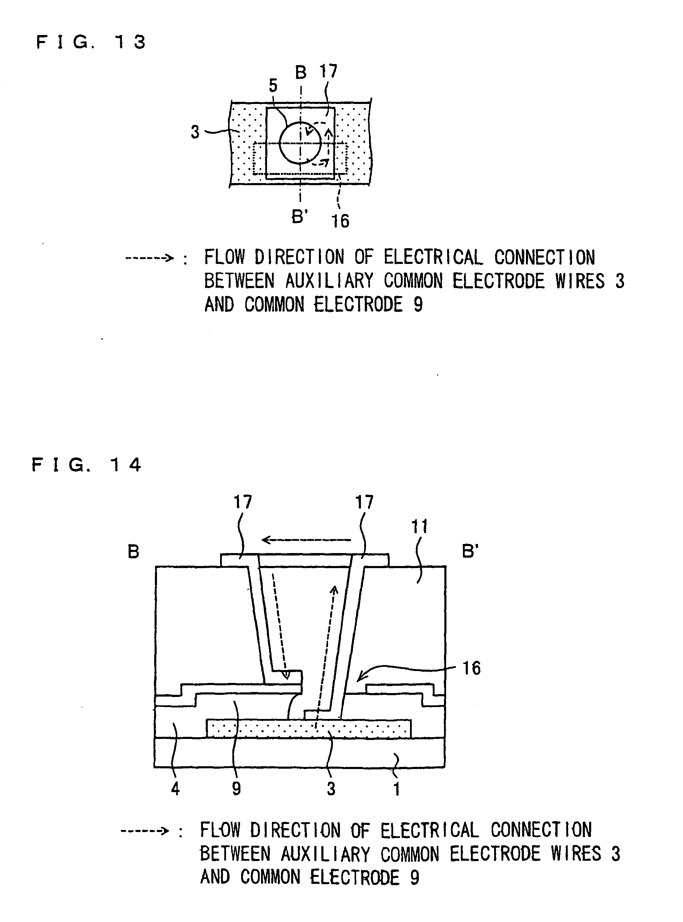

Fig. 11 illustrates Fifth Modification, and is a plane view corresponding to Fig. 2. Fig. 12 is a cross sectional view taken on a line A-A' as indicated in Fig. 11. Fig. 13 is an enlarged view of section C illustrated in Fig. 11, that is, an intersecting section of the common electrode 9 and the common electrode wires 3. Fig. 14 is a cross sectional view taken on a line B-B' as indicated in Fig. 13. As illustrated in Fig. 11, the pixel electrodes 13 illustrated in the Fifth Modification are cut off at a part in which the common electrodes 9 and the auxiliary common electrode wires 3 intersect with each other. At this intersecting section, contact electrode pads 17 are provided separated from the pixel electrodes 13. The contact electrode pads 17 electrically connect the common electrodes 9 and the auxiliary common electrode wires 3.

Reference numeral 16 in Fig. 13 illustrates an opening of the common electrodes 9. That is to say, in the Fifth Modification, an opening is provided at the intersecting section of the common electrodes 9 and the auxiliary common electrode wires 3, as illustrated in Figs. 12 and 14. Further, as obvious from Figs. 12 and 14, the interlayer insulating film 11 and the gate insulating film 4 are hollowed out at a position in which the contact electrode pad 17 is provided.

In the representative example, the common electrodes 9 and the auxiliary electrode wires 3 are electrically connected to each other via the contact holes 5 provided on the gate insulating film 4. In comparison, the Fifth Modification provides the contact electrode pads 17 that are connected to both the common electrodes 9 and the auxiliary common electrode wires 3, as illustrated in Figs. 12 and 14. Namely, the common electrodes 9 and the auxiliary common electrode wires 3 are connected to each other via the contact electrode pads 17.

The contact electrode pads 17 are formed along the interlayer insulating film 11, and one end is connected to the common electrodes 9, and the other end is connected to the auxiliary common electrode wires 3. This allows electrical connection between the auxiliary common electrode wires 3 and the common electrodes 9 as indicated by the broken arrow in Fig. 14. The contact electrode pad 17 can be simultaneously formed with the formation of the pixel electrodes 13. Note that, although the contact electrode pads 17 connect the common electrodes 9 and the auxiliary common electrode wires 3 in the extending direction of the source wires 8a, this is simply one example, and the common electrodes 9 and the auxiliary common electrode wires 3 may be connected in an extending direction of the gate wires 2, for example.

A reason why the opening 16 of the common electrodes 9 and the contact electrode pads 17 are arranged as illustrated in Figs. 12 and 14 are later described with reference to drawings.

In the representative example, six mask processes are required for manufacturing the active matrix substrate. In comparison, the Fifth Modification can manufacture the active matrix substrate in a five-mask process. A reason of this is because the contact holes 5 can be formed simultaneously with a photopatterning of the interlayer insulating film 11. This enables elimination of a photo step for forming the contact holes 5.

The following description explains a method for manufacturing the active matrix substrate illustrated in Fig. 12.

### (Step 1)

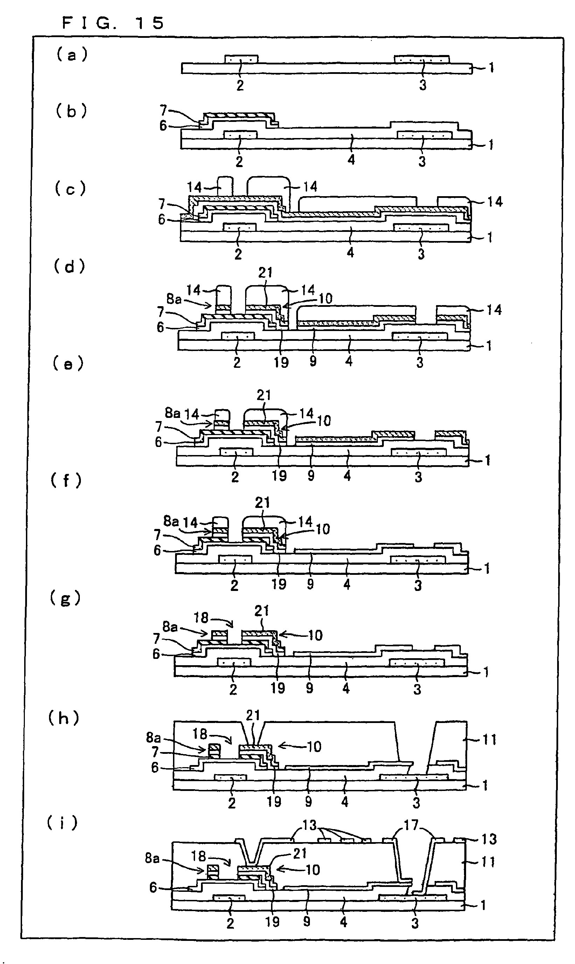

As illustrated in (a) of Fig. 15, a film is formed on the insulating substrate 1 by sputtering Ti/Al/Ti or the like in a thickness of approximately 250 nm. Thereafter, by a photolithography method, the gates 2 and the auxiliary common electrode wires 3 are formed spaced apart from each other. In this step 1, a first mask is to be used.

### (Step 2)

By a plasma CVD (chemical vapor deposition) method, the gate insulating film (silicon nitride; SiNx) 4, the a-Si layer 6, and the n+-Si layer 7 are formed consecutively in this order having a thickness of approximately 300 nm, 150 nm, and 50 nm, respectively. After formation of the films, positions corresponding to the gates 2 and the auxiliary common electrode wires 3 are patterned as an island-shape by the photolithography method, as illustrated in (b) of Fig. 15. Note that a channel section of the TFTs 18 is still not formed at this point. In the step 2, a second mask is to be used.

### (Step 3)

A transparent conductive layer made of ITO is formed as a lower layer having a thickness of approximately 100 nm, and a metal layer made of Mo/Al/MoN or the like is formed as an upper layer having a thickness of approximately 150 nm, consecutively, by sputtering. Following formation of the film, a photoresist 14 is formed as illustrated in (c) of Fig. 15. The photoresist 14 causes, by a halftone exposure method, a remaining amount of photoresist on the film in (i) an area in which the transparent conductive film and the metal layer are both to be removed, (ii) a first area (an area forming the sources 8a or the drains 10) in which the transparent conductive film and the metal layer are both to remain, and (ii) a second area (an area forming the common electrodes 9) in which the transparent conductive film and the metal layer are both to remain, to be approximately 0 nm, 3000 nm, and 1000 nm, respectively. Although not illustrated in the drawings, the photoresist 14 that causes a film to remain by an amount of approximately 3000 nm is also formed on an area on which the common electrode wires 8b are to be formed. In this step, a third mask is to be used.

### (Step 4)

The metal film is etched by a wet etching method by use of a wet etching liquid containing a phosphoric acid - hydrochloric acid - nitric acid type etching liquid. Further, the transparent conductive film is etched by a wet etching method by use of a ferric chloride etchant. This forms the sources 8a and the drains 10, as illustrated in (d) of Fig. 15.

The sources 8a and the drains 10 are formable as a double-layered structure by carrying out this step, having the transparent conductive film (ITO) 19 as a lower layer and the metal layer 21 as an upper layer. Further, the common electrodes 9 are simultaneously formed.

Note that although not illustrated in the drawings, the common electrode wires 8b are also formed in this step.

### (Step 5)

The photoresist 14 provided on the area on which the common electrodes 9 are formed is removed by a dry etching method utilizing a gas containing O₂, as illustrated in (e) of Fig. 15.

### (Step 6)

As illustrated in (f) of Fig. 15, the metal film on the area on which the common electrodes 9 are formed is removed by the wet etching method utilizing the phosphoric acid - hydrochloric acid - nitric acid type etching liquid. Thereafter, channel sections including the a-Si layer 6 and the n⁺-Si layer 7 are formed by the dry etching method utilizing a gas containing SF₆. This forms, for each pixel, TFTs 18 which serve as a switching element.

### (Step 7)

The photoresist on the area on which the sources 8a, the common electrode wires 8b, and the drains 10 are formed is removed by the dry etching method utilizing the gas containing O₂, as illustrated in (g) of Fig. 15. Note that, although not illustrated in the drawing, the photoresist on the area on which the common electrode wires 8b are formed is simultaneously removed.

### (Step 8)

A silicon nitride film is formed in a thickness in a range of approximately 150 nm to 650 nm so as to serve as the interlayer insulating film 11, by the plasma CVD method, as illustrated in (h) of Fig. 15. This interlayer insulating film 11 is then etched in a predetermined pattern by the photolithography method so as to form the contact holes 5 and 12, and the wires lead-out terminal pad section (not illustrated) of the gate wires 2 and source wires 8a. Simultaneously, dry etching of the gate insulating film 4 is carried out by use of the interlayer insulating film 11 as a mask, so that the contact holes 5 are hollowed to reach the auxiliary common electrode wires 3.

Note that a fourth mask is to be used in this step.

### (Step 9)

The transparent conductive film made of ITO is formed by sputtering in a thickness of approximately 100 nm on the interlayer insulating film 11, as illustrated in (i) of Fig. 15. Thereafter, the pixel electrodes 13, and the contact electrode pads 17 that electrically connect the common electrodes 9 and the auxiliary common electrode wires 3, are etched in a predetermined pattern by the photolithography method. This concludes the formation of the active matrix substrate as illustrated in Fig. 12. In this step, a fifth mask is to be used.

As described above, the Fifth Modification can manufacture the active matrix substrate by use of five masks.

Next is an explanation of each of the cases of using five masks and six masks, with reference to drawings.

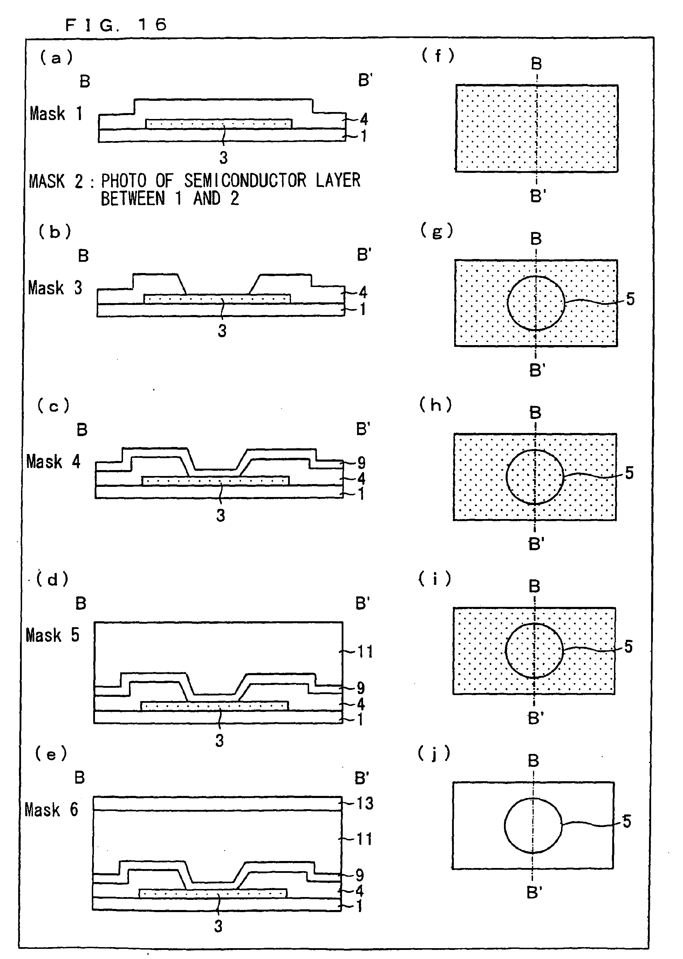

In Fig. 16, (a) through (e) are cross sectional views illustrating a manufacturing process of the contact hole 5 part of the active matrix substrate in a case where six masks are used, and (f) through (j) are schematic views illustrating plane views of Figs. (a) through (e), respectively.

A first mask is used so as to form the auxiliary common electrode wires 3, as illustrated in (a) of Fig. 16. A second mask is used in a photolithography method of a semiconductor layer (not illustrated). A third mask is used so as to form the contact holes 5, as illustrated in (b) of Fig. 16. A fourth mask is used so as to form the common electrodes 9, as illustrated in (c) of Fig. 16. A fifth mask is used so as to pattern the interlayer insulating film 1 1, as illustrated in (d) of Fig. 16. A sixth mask is used so as to form the pixel electrodes 13, as illustrated in (e) of Fig. 16.

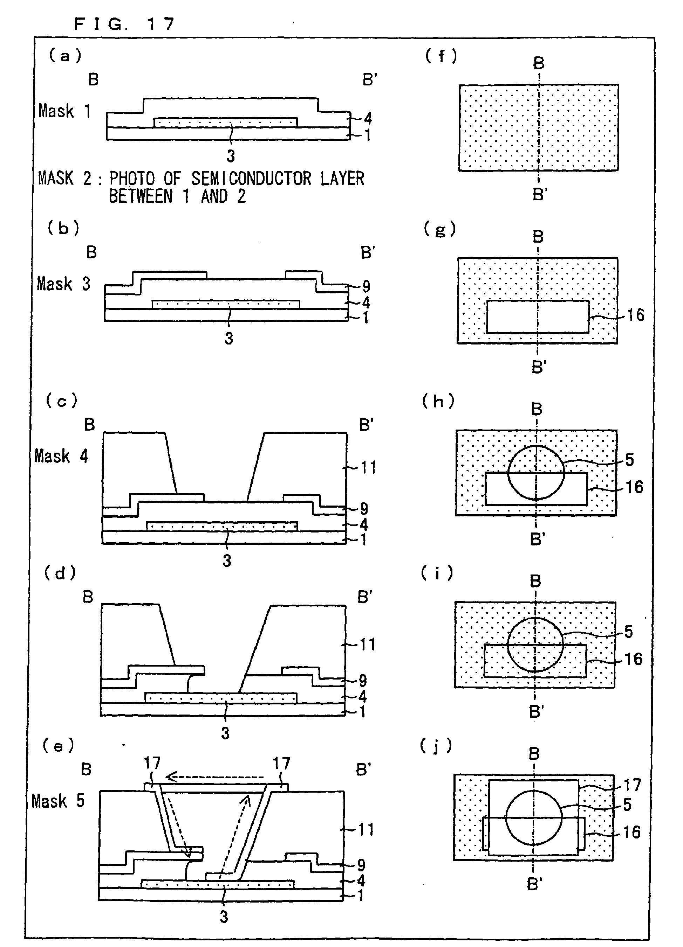

On the other hand, in Fig. 17, (a) through (e) are cross sectional views illustrating a manufacturing process of the contact hole 5 part of the active matrix substrate in a case where five masks are used, and (f) through (j) are schematic views illustrating plane views of (a) through (e), respectively.

A first mask is used so as to form the auxiliary common electrode wires 3 as illustrated in (a) of Fig. 17. A second mask is used in a photolithography method of a semiconductor layer (not illustrated). A third mask is used so as to form openings 16 of the common electrodes 9, as illustrated in (b) of Fig. 17. A fourth mask is used so as to form the interlayer insulating film 11 as illustrated in (c) of Fig. 17. Formation of the contact holes 5 that extend to the auxiliary common electrode wires 3 are carried out by dry etching the gate insulating film 2 by use of the interlayer insulating film 11 as a mask. Therefore, a new mask is not necessary in (d) of Fig. 17. A fifth mask is used so as to form (i) the pixel electrodes 13 and (ii) the contact electrode pads 17 that electrically connect the common electrodes with the auxiliary common electrode wires 3, as illustrated in (e) of Fig. 17. The arrow illustrated in broken lines in (d) of Fig. 17 indicates a flowing direction of an electrical connection between the auxiliary common electrode wires 3 and the common electrodes 9.

The following description explains a reason why irregular contact holes 5 are provided in the Fifth Modification, as illustrated in Fig. 12. Two comparative examples of the Fifth Modification of the present embodiment are explained each with reference to drawings, in order to explain this reason.

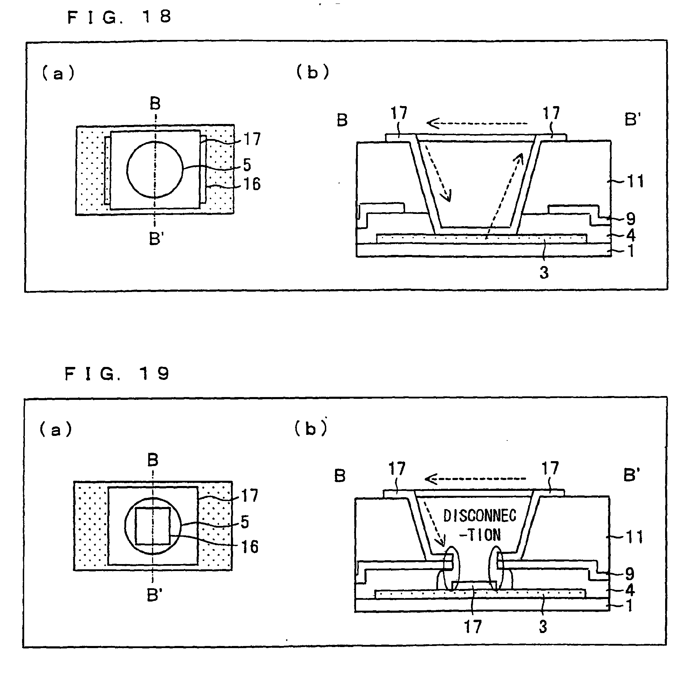

A comparative example is illustrated in (a) and (b) of Fig. 18, whose openings 16 of common electrodes 9 are larger than openings of contact holes 5. (a) of Fig. 18 is a plane view, and (b) of Fig. 18 is a cross sectional view taken on a line B-B' as indicated in (a) of Fig. 18.

In the case of the comparative example, the contact electrode pads 17 are electrically connected to the auxiliary common electrode wires 3, however cannot be electrically connected to the common electrodes 9. The reason of this is obvious; therefore it is omitted here.

Similarly, another comparative example is illustrated in (a) and (b) of Fig. 19, whose openings 16 of common electrodes 9 are smaller that of openings of contact holes. (a) of Fig. 19 is a plane view, and (b) of Fig. 19 is a cross sectional view taken on a line B-B' as indicated in (a) of Fig. 19.

In this comparative example, the contact electrode pads 17 are electrically connected to the common electrodes 9, however cannot be electrically connected to the auxiliary common electrode wires 3. The reason of this is because, since the common electrodes 9 are made of material such as ITO, the common electrodes 9 cannot be dry etched when the contact holes 5 are hollowed to the auxiliary common electrode wires 3 by dry etching the gate insulating film 4 by use of the interlayer insulating film 11 as a mask. As a result, the gate insulating film 4 becomes back tapered, in other words, peaked, which causes the contact electrode pads 17 to be disconnected.

In view of these comparative examples, the active matrix substrate in the Fifth Modification of the present embodiment is so arranged that the contact electrode pads 17 are electrically connectable to both the common electrodes 9 and the auxiliary common electrode wires 3. That is to say, the Fifth Modification is so arranged that both arrangements of the two comparative examples are taken into account. Furthermore, in other words, the contact electrode pads 17 are connected to (i) the auxiliary common electrode wires 3 on a first end sections side of the common electrodes 9 located outside of an outer edge of the respective one of the contact holes 5, and (ii) the common electrodes on a second end sections side of the common electrodes 9 located inside of the outer edge of the respective one of the contact holes 5.

The regular six mask process requires, before the formation of the sources and the drains, adding of a photo step so as to form the contact holes 5 that electrically connect the common electrodes 9 with the auxiliary common electrode wires 3. In a five mask process, the photo step for forming the contact holes 5 is not carried out before the formation of the sources and the drains. Instead, openings are provided on parts of the common electrodes 9 (so as to allow hollowing out of the contact holes 5 to the bottommost layer of the auxiliary common electrode wires 3 later on). This allows the formation of the contact holes 5 simultaneously with the photopatterning of the interlayer insulating film 11. Thereafter, the contact electrode pads 17 that electrically connect the common electrodes 9 with the auxiliary common electrode wires 3 are formed at the time when the pixel electrodes 13 are formed. This enables the manufacture of the active matrix substrate by use of the five masks. Moreover, the arrangement described in claim 1 (having no auxiliary common electrode wires) does not require the foregoing processes, and is of a five-mask process. This is because the photopatterning step of the contact holes 5 carried out before the formation of the sources and the drains is originally not included.

### (Sixth Modification)

In the representative example, the pixel electrodes are of a straight comblike shape. In comparison, Sixth Modification adds a change in a shape of the pixel electrodes 13.

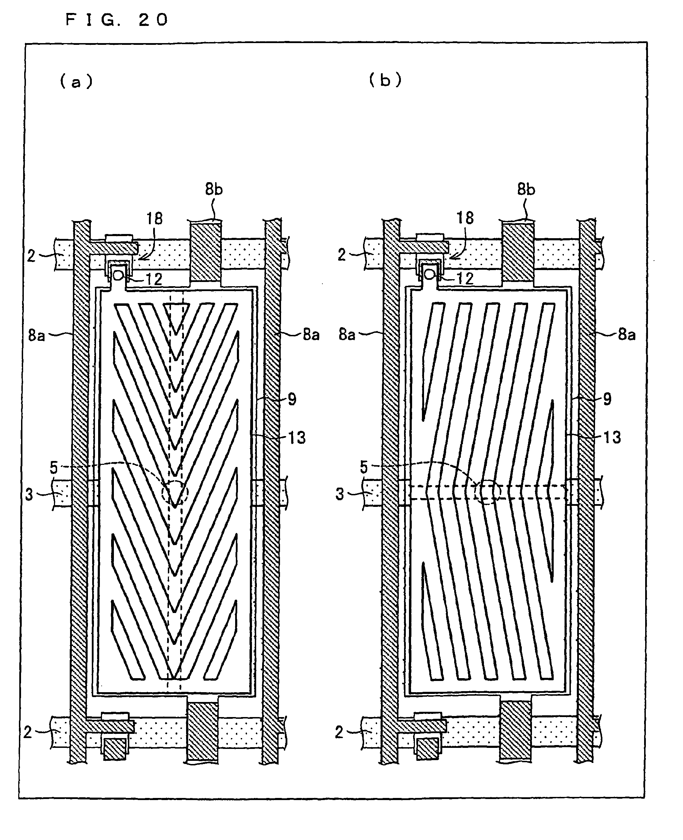

For example, the pixel electrodes 13 may be of a V-shape whose center is positioned mid between two adjacent ones of the source wires 8a in the pixel areas, as illustrated in (a) of Fig. 20. The pixel electrode 13 may be of a V-shape whose center is positioned mid between two adjacent ones of the gate wires 2 in the pixel areas. Note that the present modification has the metal layer 21 which is the upper layer of the sources 8a remaining on the common electrodes 9 in areas in which a liquid crystal domain may occur. That is to say, as illustrated in (a) and (b) of Fig. 20, the metal layer 21 is provided on parts of the common electrodes 9 (broken line section in (a) and (b) of Fig. 20).

Having the pixel electrodes 13 in such a shape allows realization of a multi-domain broad angle of view.

As described above, an active matrix substrate according to the present invention includes an insulating substrate; video signal lines and scanning signal lines provided orthogonally intersecting with each other on the insulating substrate; and thin film transistors provided at intersections of the video signal lines and the scanning signal lines, the thin film transistors including gate electrodes, source electrodes, and drain electrodes, respectively, a transparent electrode layer, formed to be used as a lower layer of the source electrodes and the drain electrodes, being used as (i) common electrodes provided in pixel areas surrounded by adjacent video signal lines and adjacent scanning signal lines, respectively and (ii) common electrode wires for connecting adjacent ones of the common electrodes parallel to the video signal lines.

Therefore, it is possible to provide an active matrix substrate which is reduced in signal delay caused by resistance and signal delay caused by parasitic capacitance.

The invention being thus described, it will be obvious that the same way may be varied in many ways. Such variations are not to be regarded as a departure from the scope of the invention, and all such modifications as would be obvious to one skilled in the art are intended to be included within the scope of the following claims.

### INDUSTRIAL APPLICABILITY

The invention is applicable to a liquid crystal display device, and is particularly suitable for use in large-screen televisions and the like.

## Claims

1. An active matrix substrate comprising:
an insulating substrate (1):
video signal lines (8a) and scanning signal lines (2) provided orthogonally intersecting with each other on the insulating substrate (1); and
thin film transistors (18) provided at intersections of the video signal lines (8a) and the scanning signal lines (2), the thin film transistors (18) including gate electrodes (2), source electrodes (8a), and drain electrodes (10), respectively,
a transparent electrode layer (19), constituting a lower layer of the source electrodes (8a) and
the drain electrodes (10), and (1) common electrodes (9) provided in pixel areas surrounded by adjacent video signal lines (8a) and adjacent scanning signal lines (2), respectively **characterized in that**
(ii) common electrode wires (8b) for connecting adjacent ones of the common electrodes (9) parallel to the video signal lines (8a) are formed of the transparent electrode layer (19).

2. The active matrix substrate as set forth in claim 1, wherein:
a metal film (2) formed so as to create the gate electrodes (2) is used as auxiliary common electrode wires (3) that are provided parallel to the scanning signal lines (2), and
the auxiliary common electrode wires (3) and the common electrodes (9) are electrically connected to each other via contact holes (5, 5'), respectively.

3. The active matrix substrate as set forth in claim 2, wherein:
each of the common electrodes (9) has an opening section whose first and second end sections are located outside and inside, respectively, of an outer edge of a respective one of the contact holes (5, 5'): and
contact electrode pads (17) connected to (i) the auxiliary common electrode wires (3) on the first end sections side of the common electrodes (9), and (il) the common electrodes (9) on the second end sections side of the common electrodes (9), respectively.

4. The active matrix substrate as set forth in claim 3, wherein:
the pixel areas include pixel electrodes, and
the contact electrode pads (17) are formed to be made of a same material and in a same manufacturing step as the pixel electrodes.

5. The active matrix substrate as set forth in any one of claims 2 through 4. wherein the auxiliary common electrode wires (3) are provided substantially mid between adjacent ones of the scanning signal lines (2), respectively.

6. The active matrix substrate as set forth in any one of claims 2 through 4. wherein the auxiliary common electrode wires (3) are provided in a vicinity of one of adjacent ones of the scanning signal lines (2).

7. The active matrix substrate as set forth in any one of claims 2 through 4, wherein the auxiliary common electrode wires (3) extend to outer peripheral sections of the common electrodes (9), and extend in the outer peripheral sections so as to be parallel to the video signal lines (8a), respectively.

8. The active matrix substrate as set forth in claim 7, wherein the auxiliary common electrode wires (3) also extend to the outer peripheral sections of the common electrodes (9), and extend in the outer peripheral sections so as to be parallel to the scanning signal lines (2), respectively.

9. The active matrix substrate as set forth in any one of claims 1 through 4. wherein a metal layer (21, 22. 25) is provided so as to surround outer peripheries of the common electrodes (9), the metal layer (21, 22, 25) being stacked to be used as an upper layer of the source electrodes (8a) and the drain electrodes (10).

10. The active matrix substrate as set forth in claim 9, wherein the metal layer (21, 22, 25) is formed on parts on which the common electrode wires (8b) are provided.

11. The active matrix substrate as set forth in any one of claims 1 through 4. wherein a metal layer (21. 22, 25) is provided on intersections of the common electrode wires (8b) and the scanning signal lines (2).

12. The active matrix substrate as set forth in any one of claims I through 4, further comprising an interlayer insulating film including at least two layers, the two layers being a layer composed of an inorganic film (23) and a layer (24) composed of a low dielectric constant organic material.

13. A liquid crystal display device comprising an active matrix substrate as set forth in any one of claims 1 through 4.

## Patentansprüche

1. Aktivmatrixsubstrat, mit:
einem isolierenden Substrat (1);
Videosignalleitungen (8a) und Abtastsignalleitungen (2), die auf dem isolierenden Substrat (1) so vorgesehen sind, dass sie sich senkrecht schneiden; und
Dünnschichttransistoren (18), die an den Schnittpunkten der Videosignalleitungen (8a) und der Abtastsignalleitungen (2) vorgesehen sind, wobei die Dünnschichttransistoren (18) jeweils Gate-Elektroden (2), Source-Elektroden (8a) und Drain-Elektroden (10) enthalten,
einer lichtdurchlässigen Elektrodenschicht (19), die eine untere Schicht der Source-Elektroden (8a) und der Drain-Elektroden (10) und (i) gemeinsame Elektroden (9), die in Pixelbereichen vorgesehen sind, die von benachbarten Videosignalleitungen (8a) bzw. benachbarten Abtastsignalleitungen (2) umgeben sind, bildet,
**dadurch gekennzeichnet, dass**
aus der lichtdurchlässigen Elektrodenschicht (19) (ii) gemeinsame Elektrodendrähte (8b) zum Verbinden benachbarter gemeinsamer Elektroden (9) parallel zu den Videosignalleitungen (8a) gebildet sind.

2. Aktivmatrixsubstrat nach Anspruch 1, wobei:
eine Metallschicht (2), die gebildet ist, um die Gate-Elektroden (2) zu erzeugen, als gemeinsame Hilfselektrodendrähte (3), die parallel zu den Abtastsignalleitungen (2) vorgesehen sind, verwendet wird und
die gemeinsamen Hilfselektrodendrähte (3) und die gemeinsamen Elektroden (9) über jeweilige Kontaktlöcher (5, 5') miteinander verbunden sind.

3. Aktivmatrixsubstrat nach Anspruch 2, wobei:
jede der gemeinsamen Elektroden (9) einen Öffnungsabschnitt besitzt, dessen erster und dessen zweiter Endabschnitt sich außerhalb bzw. innerhalb einer Außenkante eines Entsprechenden der Kontaktlöcher (5, 5') befinden; und
Kontaktelektroden-Anschlussflächen (17) besitzt, die mit (i) den gemeinsamen Hilfselektrodendrähten (3) auf Seiten der ersten Endabschnitte der gemeinsamen Elektroden (9) und (ii) mit den gemeinsamen Elektroden (9) auf Seiten der zweiten Endabschnitte der gemeinsamen Elektroden (9) verbunden sind.

4. Aktivmatrixsubstrat nach Anspruch 3, wobei:
die Pixelbereiche Pixelelektroden enthalten und
die Kontaktelektroden-Anschlussflächen (17) so beschaffen sind, dass sie aus demselben Material und im selben Herstellungsschritt wie die Pixelelektroden hergestellt sind.

5. Aktivmatrixsubstrat nach einem der Ansprüche 2 bis 4, wobei die gemeinsamen Hilfselektrodendrähte (3) im Wesentlichen in der Mitte zwischen benachbarten Abtastsignalleitungen (2) vorgesehen sind.

6. Aktivmatrixsubstrat nach einem der Ansprüche 2 bis 4, wobei die gemeinsamen Hilfselektrodendrähte (3) in einer Umgebung einer Benachbarten der Abtastsignalleitungen (2) vorgesehen sind.

7. Aktivmatrixsubstrat nach einem der Ansprüche 2 bis 4, wobei sich die gemeinsamen Hilfselektrodendrähte (3) zu äußeren Umfangsabschnitten der gemeinsamen Elektroden (9) erstrecken und sich in den äußeren Umfangsabschnitten so erstrecken, dass sie zu den jeweiligen Videosignalleitungen (8a) parallel sind.

8. Aktivmatrixsubstrat nach Anspruch 7, wobei sich die gemeinsamen Hilfselektrodendrähte (3) auch zu den äußeren Umfangsabschnitten der gemeinsamen Elektroden (9) erstrecken und sich in den äußeren Umfangsabschnitten so erstrecken, dass sie zu den jeweiligen Abtastsignalleitungen (2) parallel sind.

9. Aktivmatrixsubstrat nach einem der Ansprüche 1 bis 4, wobei eine Metallschicht (21, 22, 25) so vorgesehen ist, dass sie äußere Umfänge der gemeinsamen Elektroden (9) umgibt, wobei die Metallschicht (21, 22, 25) gestapelt ist, um als eine obere Schicht der Source-Elektroden (8a) und der Drain-Elektroden (10) verwendet zu werden.

10. Aktivmatrixsubstrat nach Anspruch 9, wobei die Metallschicht (21, 22, 25) auf Teilen gebildet ist, auf denen die gemeinsamen Elektrodendrähte (8b) vorgesehen sind.

11. Aktivmatrixsubstrat nach einem der Ansprüche 1 bis 4, wobei eine Metallschicht (21, 22, 25) auf Schnittpunkten der gemeinsamen Elektrodendrähte (8b) und der Abtastsignalleitungen (2) vorgesehen sind.

12. Aktivmatrixsubstrat nach einem der Ansprüche 1 bis 4, das ferner eine Zwischenisolierschicht enthält, die wenigstens zwei Schichten enthält, wobei die zwei Schichten eine Schicht, die aus einer anorganischen Schicht (23) gebildet ist, und eine Schicht (24), die aus einem organischen Material mit niedriger Dielektrizitätskonstante gebildet ist, sind.

13. Flüssigkristallanzeigevorrichtung, die ein Aktivmatrixsubstrat nach einem der Ansprüche 1 bis 4 enthält.

## Revendications

1. Substrat de matrice active comprenant :
un substrat isolant (1) ;
des lignes de signal vidéo (8a) et des lignes de signal de balayage (2) placées orthogonalement et se coupant les unes les autres sur le substrat isolant (1) ; et
des transistors à couches minces (18) placés aux intersections des lignes de signal vidéo (8a) et des lignes de signal de balayage (2), les transistors à couches minces (18) comprenant des électrodes grilles (2), des électrodes sources (8a), et des électrodes drains (10), respectivement,
une couche transparente d'électrodes (19), constituant une couche inférieure des électrodes sources (8a) et des électrodes drains (10), et (i) des électrodes communes (9) situées dans des zones de pixels entourées par des lignes de signal vidéo (8a) adjacentes et des lignes de signal de balayage (2) adjacentes, respectivement
**caractérisé en ce que**
(ii) des fils d'électrodes communes (8b) pour raccorder celles étant adjacentes des électrodes communes (9) parallèles aux lignes de signal vidéo (8a) sont formés à partir de la couche transparente d'électrodes (19).

2. Substrat de matrice active selon la revendication 1, dans lequel :
une pellicule de métal (2) formée pour créer les électrodes grilles (2) est utilisée comme fils d'électrodes communes auxiliaires (3) qui sont placés parallèles aux lignes de signal de balayage (2), et les fils d'électrodes communes auxiliaires (3) et les électrodes communes (9) sont électriquement connectés les uns aux autres par l'intermédiaire de trous de contact (5, 5'), respectivement.

3. Substrat de matrice active selon la revendication 2, dans lequel :
chacune des électrodes communes (9) possède une section ouverte dont les première et deuxième sections d'extrémité sont situées à l'extérieur et à l'intérieur, respectivement, d'un bord extérieur de l'un des trous de contact (5, 5') correspondant ; et
des plages d'électrode de contact (17) connectées respectivement aux (i) fils d'électrodes communes auxiliaires (3) sur le côté des premières sections d'extrémité des électrodes communes (9), et (ii) aux électrodes communes (9) sur le côté des deuxièmes sections d'extrémité des électrodes communes (9) ,.

4. Substrat de matrice active selon la revendication 3, dans lequel :
les zones de pixels comprennent des électrodes de pixel, et
les plages d'électrode de contact (17) sont formées pour être constituées de la même matière et lors d'une même étape de fabrication que les électrodes de pixel.

5. Substrat de matrice active selon l'une quelconque des revendications 2 à 4, dans lequel les fils d'électrodes communes auxiliaires (3) sont placés sensiblement au milieu entre celles étant adjacentes des lignes de signal de balayage (2), respectivement.

6. Substrat de matrice active selon l'une quelconque des revendications 2 à 4, dans lequel les fils d'électrodes communes auxiliaires (3) sont placés à proximité de l'une de celles étant adjacentes des lignes de signal de balayage (2).

7. Substrat de matrice active selon l'une quelconque des revendications 2 à 4, dans lequel les fils d'électrodes communes auxiliaires (3) se prolongent vers des sections périphériques extérieures des électrodes communes (9), et se prolongent dans les sections périphériques extérieures afin d'être parallèles aux lignes de signal vidéo (8a), respectivement.

8. Substrat de matrice active selon la revendication 7, dans lequel les fils d'électrodes communes auxiliaires (3) se prolongent également vers les sections périphériques extérieures des électrodes communes (9), et se prolongent dans les sections périphériques extérieures afin d'être parallèles aux lignes de signal de balayage (2), respectivement.

9. Substrat de matrice active selon l'une quelconque des revendications 1 à 4, dans lequel une couche de métal (21, 22, 25) est placée de manière à entourer les périphéries extérieures des électrodes communes (9), la couche de métal (21, 22, 25) étant empilée pour être utilisée comme couche supérieure des électrodes sources (8a) et des électrodes drains (10).

10. Substrat de matrice active selon la revendication 9, dans lequel la couche de métal (21, 22, 25) est formée sur des zones sur lesquelles les fils d'électrodes communes (8b) sont placés.

11. Substrat de matrice active selon l'une quelconque des revendications 1 à 4, dans lequel une couche de métal (21, 22, 25) est placée aux intersections entre les fils d'électrodes communes (8b) et les lignes de signal de balayage (2).

12. Substrat de matrice active selon l'une quelconque des revendications 1 à 4, comprenant en outre une pellicule entre-couche isolante comprenant au moins deux couches, les deux couches étant une couche composée d'un film non organique (23) et une couche (24) composée d'un matériau organique de faible constante diélectrique.

13. Dispositif d'affichage à cristaux liquides comprenant un substrat de matrice active selon l'une quelconque des revendications 1 à 4.
